(19) Europäisches Patentamt
European Patent Office
Office européen des brevets

(11) **EP 3 596 751 B1**

(12) **EUROPÄISCHE PATENTSCHRIFT**

(45) Veröffentlichungstag und Bekanntmachung des Hinweises auf die Patenterteilung:
**30.03.2022   Patentblatt 2022/13**

(21) Anmeldenummer: **18708369.6**

(22) Anmeldetag: **22.02.2018**

(51) Internationale Patentklassifikation (IPC):
*H01L 21/67* (2006.01)     *H01L 21/68* (2006.01)
*G03F 7/20* (2006.01)

(52) Gemeinsame Patentklassifikation (CPC):
**H01L 21/681; G03F 7/70516; G03F 7/706; H01L 21/67092**

(86) Internationale Anmeldenummer:
**PCT/EP2018/054433**

(87) Internationale Veröffentlichungsnummer:
**WO 2018/166772 (20.09.2018 Gazette 2018/38)**

(54) **VERFAHREN UND VORRICHTUNG ZUR AUSRICHTUNG ZWEIER OPTISCHER TEILSYSTEME**

METHOD AND APPARATUS FOR ALIGNING TWO OPTICAL SUBSYSTEMS

PROCÉDÉ ET DISPOSITIF POUR ORIENTER DEUX SYSTÈMES PARTIELS OPTIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.03.2017   DE 102017105697**

(43) Veröffentlichungstag der Anmeldung:
**22.01.2020   Patentblatt 2020/04**

(73) Patentinhaber: **EV Group E. Thallner GmbH
4782 St. Florian am Inn (AT)**

(72) Erfinder: **POVAZAY, Boris
1220 Wien (AT)**

(74) Vertreter: **Schneider, Sascha et al
Becker & Müller
Patentanwälte
Turmstraße 22
40878 Ratingen (DE)**

(56) Entgegenhaltungen:
WO-A1-2014/202106     WO-A1-2015/082020
JP-A- 2003 303 865     US-A1- 2007 252 994

EP 3 596 751 B1

**Beschreibung**

In der Halbleiterindustrie werden Ausrichtungsanlagen (engl.: aligner) verwendet, um Substrate, insbesondere Wafer, zueinander auszurichten, damit sie in einem weiteren Prozessschritt miteinander verbunden werden. Den Verbindungsvorgang nennt man Bonden. Die Ausrichtung der Substrate zueinander erfolgt durch Ausrichtungsmarken, die sich an den Oberflächen der Substrate befinden. Die Ausrichtungsmarken an gegenüberliegenden Seiten der gegenüberliegenden Substrate sind insbesondere komplementär zueinander.

Ausrichtungsvorgänge bei denen sich die Ausrichtungsmarken an den zu verbondenden Substratoberflächen befinden werden als face-to-face Ausrichtungen bezeichnet. Sofern die Substrate nicht für die zu vermessende elektromagnetische Strahlung transparent sind, müssen Verfahren entwickelt werden, um die Marken zu vermessen, bevor die Substrate aneinander angenähert werden.

Eine sehr lange praktizierte Methode bestand darin, eine Kamera zwischen die Substrate einzufügen, die vor der Annäherung entfernt wurde. Dies brachte mehrere Nachteile mit sich. Erstens hatte die Kamera eine Partikelkontamination an mindestens dem unteren Substrat zur Folge und zweitens musste der Abstand zwischen den Substraten relativ groß gewählt werden um die Kamera zwischen beiden Substraten zu platzieren. Der große Abstand hatte den Nachteil, dass der Verfahrweg bei der Annäherung der beiden Substrate, nachdem die Kamera entfernt wurde, sehr groß war und sich die Substrate bei der gegenseitigen Annäherung lateral verschoben und daher von ihrer vorherigen, optimalen Ausrichtung zueinander abwichen.

Eine Verbesserung der face-to-face Ausrichtung stellt die Ausrichtungsanlage der Druckschrift US6214692B1 dar. In der offenbarten Ausrichtungsanlage wurde auf die Verwendung einer, zwischen die Substrate einzuschiebenden, Kamera gänzlich verzichtet. Stattdessen wurden zwei Optikgruppen mit jeweils zwei zueinander gegenüberliegenden Optiken verwendet, um ein System mit zwei Referenzpunkten zu schaffen, in Bezug auf das die Substrate wechselseitig positioniert werden. Bei den Referenzpunkten handelte es sich um die Schnittpunkte der optischen Achsen zweier zueinander gegenüberliegender Optiken. Der entsprechende Prozess zur Kalibrierung derartiger Optiken wurde ausgiebig in den Figuren 2c und 2e der Druckschrift WO2014202106A1 oder den Figuren 5a und 5b der Druckschrift WO2015082020A1 offenbart und beschrieben. Ein weiteres Verfahren zur Ausrichtung zweier optischer Teilsysteme zueinander ist etwa auch in der JP 2003 303865 A beschrieben.

Das Problem mit dem Stand der Technik, insbesondere dem Kalibrierverfahren gemäß den Figuren 2c und 2e der Druckschrift WO2014202106A1 oder gemäß den Figuren 5a und 5b der Druckschrift WO2015082020A1 besteht darin, dass ein Kalibriersubstrat benötigt wird, in Bezug auf das eine Kalibrierung der optischen Achsen der Optiken durchgeführt wird. Die obere und die unteren Optiken werden auf eine Ausrichtungsmarke im, insbesondere transparenten, Substrat kalibriert. Damit werden die linken optischen Achsen auf einen linken Fokuspunkt und die rechten optischen Achsen auf einen rechten Fokuspunkt eingestellt.

Es ist daher die Aufgabe der vorliegenden Erfindung, ein Verfahren und ein System anzugeben, welche die Nachteile des Stands der Technik nicht aufweisen und insbesondere mit denen zwei Optiken vereinfacht zueinander ausgerichtet bzw. kalibriert werden können.

Diese Aufgabe wird mit den Merkmalen der nebengeordneten Ansprüche gelöst. Vorteilhafte Weiterbildungen der Erfindung sind in den Unteransprüchen angegeben.

Die Erfindung beschreibt insbesondere, wie die beiden Bildebenen der beiden zueinander gegenüberliegenden Optiken und/oder die optischen Achsen der beiden Optiken zueinander ausgerichtet werden können.

Auf die Verwendung eines Kalibriersubstrats gemäß der Druckschrift WO2014202106A1 kann vorteilhaft verzichtet werden.

Erfindungsgemäß vorgesehen ist ein Verfahren zur Ausrichtung zweier gegenüberliegend, insbesondere übereinander, angeordneter optischer Teilsysteme eines optischen Systems, mit den folgenden Schritten:

- Projektion von Ausrichtungsmarken in eine Bildebene des ersten, insbesondere unteren, optischen Teilsystems,
- Projektion der Ausrichtungsmarken von der ersten Bildebene auf eine sensitive Oberfläche des zweiten, insbesondere oberen, optischen Teilsystems,
- Ausrichtung der optischen Teilsysteme zueinander, so dass Projektionen der Ausrichtungsmarken in einem Schärfentiefebereich der sensitiven Oberfläche an idealen Positionen abgebildet werden, wobei ein Keilfehler zwischen der Bildebene des ersten optischen Teilsystems und einer Bildebene des zweiten optischen Teilsystems korrigierbar ist.

Die Tiefenschärfebereiche und/oder die Schärfentiefebereiche aller optischer Elemente, insbesondere der Optiken, liegen zwischen 1nm und 10mm, vorzugsweise zwischen 10nm und 1mm, noch bevorzugter zwischen 50nm und 500$\mu$m, am bevorzugtesten zwischen 500nm und 250$\mu$m, am allerbevorzugtesten zwischen 1$\mu$m und 100$\mu$m.

In einer bevorzugten Ausführungsform ist es vorgesehen, dass Licht zur Beleuchtung der Ausrichtungsmarken über mindestens eine Lichtquelle, insbesondere eine Lampe, bevorzugt eine Halogenlampe, noch bevorzugter eine LED, am bevorzugtestem eine Laserlichtquelle, und mindestens einen Spiegel in das erste und/oder zweite optische Teilsystem eingekoppelt wird. Mit einer solchen externen Lichtquelle kann vorteilhaft eine besonders helle Ausleuchtung der Ausrichtungsmarken erreicht werden.

Gemäß einer anderen bevorzugten Ausführungsform ist es vorgesehen, dass an mindestens einer Stelle der optischen Teilsysteme, insbesondere an einer ersten Kamera und/oder an einem Spiegel, Umgebungslicht zur Beleuchtung der Ausrichtungsmarken eingekoppelt wird, wobei bevorzugt eine Abschirmung der optischen Teilsysteme nicht verbaut wird. Dadurch ist es vorteilhaft möglich, ohne zusätzliche externe Lichtquellen die Ausrichtungsmarken zu beleuchten.

Gemäß einer anderen besonders bevorzugten Ausführungsform ist es vorgesehen, dass die Ausrichtungsmarken von einem Ausrichtungsmarkenprojektionssystem auf eine erste sensitive Oberfläche eines ersten Kamerachips einer ersten Kamera projiziert werden, wobei die Ausrichtungsmarken insbesondere ein LED Feld umfassen und/oder als Masken ausgebildet sind. Dadurch ist es vorteilhaft nicht erforderlich, dass die Ausrichtungsmarken in den Kamerachip eingebracht werden müssen.

Gemäß einer anderen bevorzugten Ausführungsform ist es vorgesehen, dass die optischen Teilsysteme zwei sich gegenüberliegend angeordnete Optiken, umfassen, deren Bildebenen und/oder optische Achsen zueinander ausgerichtet werden.

Dadurch ist vorteilhaft eine besonders effiziente Ausrichtung der optischen Teilsysteme beziehungsweise der Optiken möglich.

Gemäß einer anderen bevorzugten Ausführungsform ist es vorgesehen, dass zumindest die Optiken Teil einer Anlage zur Ausrichtung von Substraten, insbesondere Wafern, sind. Hierdurch ist vorteilhaft eine erhebliche Verbesserung einer Anlage zur Ausrichtung von Substraten möglich.

Gemäß einer anderen bevorzugten Ausführungsform weist das erfindungsgemäße Verfahren, den folgenden Ablauf auf:

- Anordnung von Ausrichtungsmarken in der Nähe und/oder auf einer ersten sensitiven Oberfläche eines ersten Kamerachips einer ersten Kamera und/oder Projektion von Ausrichtungsmarken auf eine erste sensitive Oberfläche eines ersten Kamerachips einer ersten Kamera,
- Projektion der Ausrichtungsmarken vom ersten Kamerachip über das erste optische Teilsystem in die erste Bildebene, wobei das erste optische Teilsystem die erste Optik aufweist, wobei die erste Bildebene zwischen den Optiken angeordnet ist,
- Projektion der Ausrichtungsmarken von der ersten Bildebene über das zweite optische Teilsystem auf die zweite sensitive Oberfläche eines zweiten Kamerachips einer zweiten Kamera, wobei das zweite optische Teilsystem die zweite Optik aufweist,
- insbesondere Ausrichtung der Optiken zueinander, so dass projizierte Ausrichtungsmarken der Ausrichtungsmarken scharf auf der zweiten Kamera abgebildet werden und Positionen der projizierten Ausrichtungsmarken mit gewünschten und/oder idealen Positionen übereinstimmen.

Gemäß einer anderen bevorzugten Ausführungsform ist es vorgesehen, dass die Optiken zur Ausrichtung translatorisch und/oder rotatorisch zueinander bewegt werden. Dadurch ist vorteilhaft eine besonders genaue Ausrichtung möglich.

Gemäß einer anderen bevorzugten Ausführungsform ist es vorgesehen, dass die Optiken zur Ausrichtung derart angenähert werden, dass sich die erste Bildebene er ersten Optik in einem Schärfentiefebereich der zweiten Gegenstandsebene der zweiten Optik befindet. Dadurch ist vorteilhaft eine besonders scharfe Abbildung der Ausrichtungsmarken möglich.

Gemäß einer anderen bevorzugten Ausführungsform ist es vorgesehen, dass die Ausrichtungsmarken, insbesondere mittels lithographischer Verfahren, direkt auf einer ersten sensitiven Oberfläche eines ersten Kamerachips einer ersten Kamera aufgebracht sind. Dadurch ist vorteilhaft eine besonders effiziente Erzeugung der Ausrichtungsmarken möglich.

Gemäß einer anderen bevorzugten Ausführungsform ist es vorgesehen, dass die Ausrichtungsmarken direkt auf einer ersten sensitiven Oberfläche eines ersten Kamerachips aufgebracht sind, wobei die Ausrichtungsmarken eine, insbesondere eine Kreuzform aufweisende, Ansammlung nicht funktionsfähiger Pixel aufweisen. Dadurch ist vorteilhaft eine besonders einfache Erzeugung der Ausrichtungsmarken möglich.

Gemäß einer anderen bevorzugten Ausführungsform ist es vorgesehen, dass die Ausrichtungsmarken auf eine separate Markierungsplatte in einem ersten Kamerachip einer ersten Kamera aufgebracht sind, wobei der Abstand zwischen den Ausrichtungsmarken und einer ersten sensitiven Oberfläche des ersten Kamerachips kleiner 1 mm ist, vorzugsweise kleiner als 100 $\mu$m, noch bevorzugter kleiner als 10 $\mu$m, am bevorzugtesten kleiner als 1 $\mu$m, am allerbevorzugtesten kleiner als 0.1 $\mu$m. Dadurch ist vorteilhaft keine Bearbeitung des Kamerachips zur Erzeugung der Ausrichtungsmarken erforderlich.

Ein weiterer Gegenstand der vorliegenden Erfindung betrifft ein System, zur Ausrichtung zweier gegenüberliegend, insbesondere übereinander, angeordneter optischer Teilsysteme des optischen Systems, insbesondere mit einem erfindungsgemäßen Verfahren, aufweisend: Eine erste Kamera mit einem ersten Kamerachip zur Projektion von Ausrichtungsmarken in eine Bildebene des ersten, insbesondere unteren, optischen Teilsystems,

- Mittel zur Projektion der Ausrichtungsmarken von der ersten Bildebene auf eine sensitive Oberfläche des zweiten, insbesondere oberen, optischen Teilsystems,
- Mittel zur Ausrichtung der optischen Teilsysteme zueinander, so dass Projektionen der Ausrichtungsmarken in einem Schärfentiefebereich der sensitiven Oberfläche an idealen Positionen abbildbar sind, wobei ein Keilfehler zwischen der Bildebene des ersten optischen Teilsystems und einer Bildebene des zweiten optischen Teilsystems korrigierbar ist.

Die Ausführungsformen in Bezug auf das Verfahren beziehen sich auch auf das erfindungsgemäße System.

Ein weiterer Gegenstand der vorliegenden Erfindung betrifft einen Kamerachip mit Ausrichtungsmarken in der Nähe und/oder auf seiner sensitiven Oberfläche, für ein erfindungsgemäßes Verfahren. Die Ausführungen zum Verfahren beziehen sich auch auf den erfindungsgemäßen Kamerachip.

Das optische System

Die erfindungsgemäße Ausführungsform betrifft ein optisches System, bestehend aus mindestens einem ersten, unteren optischen Teilsystem und einem zweiten, oberen optischen Teilsystem. Im weiteren Verlauf der Druckschrift werden, in Rücksichtnahme auf den bevorzugten Aufbau, alle Entitäten nur mehr durch die Wörter "oben" oder "unten" bezeichnet. Das untere optische Teilsystem und das obere optische Teilsystem verfügen über mindestens ein optisches Element, insbesondere mehrere optische Elemente. Bei den optischen Elementen handelt es sich insbesondere um

    Spiegel, insbesondere

        ◦ Planspiegel
        ◦ Konvexspiegel
        ◦ Konkavspiegel

    Linsen

        ◦ Konvexlinsen

            ▪ Bikonvex

            ▪ Planarkonvex

            ▪ Konkavkonvex

        o Konkavlinsen

            ▪ Bikonkav

            ▪ Planarkonkav

            ▪ Konvexkonkav

        ◦ Fresnellinsen

Prismen
Diffraktionselemente
o Diffraktionsgitter
etc.

Bei den Spiegeln handelt es sich mit Vorzug um Kaltlichtspiegel (im Folgenden auch Kaltspiegel genannt), die Infrarotlicht aus dem eingekoppelten Licht herausfiltern, um eine unnötige und unerwünschte Erwärmung des optischen Systems zu verhindern. Insbesondere wird Licht der Wellenlänge zwischen 1000 $\mu$m und 0,8 $\mu$m, vorzugsweise zwischen 750 $\mu$m und 0,8 $\mu$m, noch bevorzugter zwischen 500 $\mu$m und 0,8$\mu$m, am bevorzugtesten zwischen 100 $\mu$m und 0,8$\mu$m am allerbevorzugtesten zwischen 50 $\mu$m und 0,8 $\mu$m gefiltert.

Die erfindungsgemäße Ausführungsform wird exemplarisch so beschrieben, dass die zu projizierenden Objekte, insbesondere Ausrichtungsmarken, von einem unteren Kamerachip, insbesondere von dessen sensitiver Oberfläche, auf einen oberen Kamerachip, insbesondere dessen sensitiver Oberfläche, projiziert werden. Denkbar ist auch, dass die Ausrichtungsmarken von einem oberen Kamerachip, insbesondere dessen sensitiver Oberfläche, auf den unteren Kamerachip, insbesondere dessen sensitiver Oberfläche, projiziert werden. Der Vollständigkeit halber wird auch der Extremfall erwähnt, dass sich Ausrichtungsmarken auf beiden Kamerachips, insbesondere deren sensitiven Oberflächen befinden, und jeweils wechselseitig auf den jeweils gegenüberliegenden Kamerachip bzw. dessen sensitive Oberfläche projiziert werden. Es wird im weiteren Verlauf der Beschreibung gezeigt, dass nur eine Projektionsrichtung von Relevanz ist, um den erfindungsgemäßen Effekt zu erzeugen.

Im weiteren Verlauf der Druckschrift wird nur mehr der exemplarische Fall behandelt werden, bei dem untere Ausrichtungsmarken auf die sensitive Oberfläche eines oberen Kamerachips projiziert werden.

Die erfindungsgemäße Ausführungsform setzt einen unteren Kamerachip voraus, der über Ausrichtungsmarken in der Nähe seiner sensitiven Oberfläche, vorzugsweise direkt auf der sensitiven Oberfläche, verfügt. Die Ausrichtungsmarken können entweder real existieren oder es handelt sich nur um, auf den unteren Kamerachip, projizierte Ausrichtungsmarken. In letzterem Fall werden diese durch ein Ausrichtungsmarkenprojektionssystem auf die sensitive Oberfläche des unteren Kamerachips projiziert. Diese Ausführungsform ist die bevorzugteste aller Ausführungsformen, da man nicht auf Kamerachips angewiesen ist, die über entsprechende Ausrichtungsmarken verfügen, sondern Ausrichtungsmarken auf jeden handelsüblichen Chip projizieren kann.

In einer ersten erfindungsgemäßen Ausführungsform werden die Ausrichtungsmarken direkt auf dem unteren Kamerachip gefertigt. Insbesondere befinden sich die Ausrichtungsmarken auf der sensitiven Oberfläche des unteren Kamerachips. Die Herstellung der Ausrichtungsmarken auf dem unteren Kamerachip sollte vorzugsweise vom Chiphersteller durchgeführt werden und ist für Kunden, die einen derartigen Chip kaufen, kaum durchführbar. Denkbar wäre eine Zerlegung des erworbenen unteren Kamerachips, sodass die sensitive Oberfläche des unteren Kamerachips vollkommen freigelegt wird. Danach könnte man mit Hilfe bestens bekannter lithographischer Verfahren entsprechende untere Ausrichtungsmarken aufbringen und den zerlegten unteren Kamerachip danach wieder zusammenbauen. Eine Entfernung des Schutzglases für die sensitive Oberfläche geht allerdings nicht selten mit einer Zerstörung des Kamerachips, insbesondere mit seiner sensitiven Oberfläche selbst, einher und ist daher meistens nicht zerstörungsfrei durchführbar.

In einer zweiten, bevorzugten erfindungsgemäßen Ausführungsform werden die unteren Ausrichtungsmarken nicht direkt auf dem unteren Kamerachip gefertigt, sondern auf einem Träger (auch Markierungsplatte genannt), der über Fixiermittel über dem verkapselten unteren Kamerachip montiert werden kann. Dabei ist darauf zu achten, dass sich die unteren Ausrichtungsmarken möglichst nahe an der Oberfläche des sensitiven Bereichs des unteren Kamerachips befinden, damit sie sich auf alle Fälle im Schärfentiefebereich der aufnehmenden, sich an der gegenüberliegenden Seite des optischen Pfads befindenden, unteren Kamera befinden.

Der Abstand zwischen den Ausrichtungsmarken und der sensitiven Oberfläche sollte kleiner als 1 mm, vorzugsweise kleiner als 100 $\mu$m, noch bevorzugter kleiner als 10 $\mu$m, am bevorzugtesten kleiner als 1 $\mu$m, am allerbevorzugtesten kleiner als 0.1 $\mu$m sein. Verkapselte Kamerachips können meistens, bis auf die letzte Deckplatte des photosensitiven Bereichs, relativ leicht zerlegt werden, sodass eine Positionierung eines erfindungsgemäßen Trägers mit Ausrichtungsmarken nahe der photosensitiven Oberfläche machbar ist.

In einer dritten, weniger bevorzugten erfindungsgemäßen Ausführungsform werden die unteren Ausrichtungsmarken auf die photosensitive Oberfläche eines unteren Kamerachips projiziert. Dies hat den Vorteil, dass jeder beliebige untere Kamerachip mit unteren Ausrichtungsmarken versehen werden kann. Damit die auf den unteren Kamerachip projizierten unteren Ausrichtungsmarken sich an den idealen Positionen befinden, muss eine Kalibrierung der, durch das Ausrichtungsmarkenprojektionssystem projizierten, unteren Ausrichtungsmarken auf den unteren Kamerachip erfolgen, bevor diese projizierten, unteren Ausrichtungsmarken über den optischen Pfad des optischen Systems auf den oberen Kamerachip projiziert werden können, um die beiden Kamerachips zueinander auszurichten.

Es ist nun der wesentliche erfindungsgemäße Aspekt, die unteren Ausrichtungsmarken des unteren Kamerachips auf die photosensitive Oberfläche des, dem unteren Kamerachip im optischen Pfad gegenüberliegenden, oberen Kamerachip zu projizieren. Um eine korrekte, scharfe Projektion der unteren Ausrichtungsmarken auf dem oberen Kamerachip zu erreichen, also scharfe projizierte, obere Ausrichtungsmarken zu erhalten, müssen die optischen Elemente, insbesondere das untere optische Teilsystem und das obere optische Teilsystem zueinander kalibriert werden. Das Ende der Kalibrierung wird dadurch festgelegt, dass die projizierten, oberen Ausrichtungsmarken sich an den idealen Positionen am oberen Kamerachip befinden.

Jedes der beiden optischen Teilsysteme verfügt über eine Gegenstandsebene und eine Bildebene, die zueinander konjugiert sind. Unter konjugierten Ebenen versteht man Ebenen, die über die Abbildungsvorschrift der Fouriertransformation miteinander mathematisch verbunden sind. Zwei Ebenen sind konjugiert zueinander, wenn sie senkrecht zur optischen Achse eines optischen Strahlengangs stehen und Objekte aus dem Gegenstandsraum in den Bildraum abbilden und umgekehrt.

Da wir exemplarisch die Projektion von unteren Ausrichtungsmarken des unteren Kamerachips auf den oberen Kamerachip betrachten, ist die untere photosensitive Oberfläche des unteren Kamerachips die erste Gegenstandsebene.

Die realen oder projizierten Ausrichtungsmarken des Ausrichtungsmarkenprojektionssystems auf der unteren photosensitiven Oberfläche des unteren Kamerachips liegen vorzugsweise in der Gegenstandsebene. Im Allgemeinen müssen sich die realen Ausrichtungsmarken nur im Schärfentiefebereich um die Gegenstandsebene befinden.

Das untere optische Teilsystem projiziert diese Ausrichtungsmarken nun in seine Bildebene. Bei dieser Bildebene handelt es sich um eine erste, untere Bildebene. Diese untere Bildebene befindet sich auf alle Fälle zwischen den beiden Optiken, deren optische Pfade zueinander kalibriert werden müssen. Das zweite optische Teilsystem verfügt ebenfalls über eine optische Ebene zwischen den Optiken. Diese optische Ebene wirkt nun aber als Gegenstandsebene und hat die Aufgabe, die auf die untere Bildebene projizierten Ausrichtungsmarken der photosensitiven Oberfläche des unteren Kamerachips, auf die zweite, obere Bildebene des oberen optischen Teilsystems zu projizieren. Die obere Bildebene koinzidiert daher mit der sensitiven Oberfläche des oberen Kamerachips. Damit das, in die untere Bildebene projizierte Bild der Ausrichtungsmarken auch möglichst verlustfrei und vor allem scharf auf die obere Bildebene abgebildet wird, müssen untere Bildebene und obere Gegenstandsebene möglichst deckungsgleich sein.

Auf Grund der Tatsache, dass die untere Bildebene des unteren optischen Teilsystems und die obere Gegenstandsebene des oberen optischen Teilsystems im Allgemeinen nicht deckungsgleich sind oder nicht einmal im Schärfentiefebereich der jeweils anderen optischen Ebene liegen, ist eine Änderung der optischen Teilsysteme, insbesondere der optischen Elemente, notwendig. Diese Änderung bedingt insbesondere eine translatorische und/oder rotatorische Anpassung der optischen Elemente des unteren und/oder oberen optischen Teilsystems, insbesondere eine translatorische und/oder rotatorische Änderung der Optiken. Ziel der erfindungsgemäßen Ausführungsform ist es, die unteren Ausrichtungsmarken des unteren Kamerachips nicht nur scharf auf die photosensitive Oberfläche des oberen Kamerachips zu projizieren, sondern auch die optischen Elemente im optischen System solange anzupassen, bis die Positionen der projizierten Ausrichtungsmarken mit den theoretisch gewünschten, idealen übereinstimmen. Vorzugsweise werden im unteren und oberen optischen Teilsystem dieselben Kamerachips verwendet. Damit handelt es sich bei den Positionen der ideal projizierten Ausrichtungsmarken um dieselben Detektorkoordinaten, welche auch die zu projizierenden Ausrichtungsmarken auf dem unteren Kamerachip aufweisen. Die optischen Systeme werden also so verändert und angepasst, dass die Marken innerhalb eines frei gewählten Toleranzbereichs hinsichtlich der Idealposition liegen.

Prozess

Der erfindungsgemäße Prozess kann insbesondere zur Kalibrierung der Optiken in den Anlagen der Druckschriften US6214692B1, WO2011042093A1, WO2014202106A1 und WO2015082020A1 verwendet werden. Dadurch wird die Allgemeinheit des Prozesses allerdings nicht beschränkt. Im Allgemeinen kann der erfindungsgemäße Prozess zur, insbesondere vollautomatischen, Kalibrierung zweier beliebiger Optiken verwendet werden.

In einem ersten erfindungsgemäßen Prozessschritt erfolgt eine Annäherung der beiden optischen Ebenen zueinander, sodass sich die untere Bildebene im Schärfentiefebereich der oberen Gegenstandsebene bzw. die obere Gegenstandsebene im Schärfentiefebereich der unteren Bildebene befindet. Im erfindungsgemäßen ersten Prozessschritt ist die projizierte linke, obere Ausrichtungsmarke oder die rechte, obere Ausrichtungsmarke noch nicht notwendigerweise scharf. Insbesondere müssen sich auch noch nicht notwendigerweise beide oberen Ausrichtungsmarken im Sichtbereich (engl.: field of view) der oberen Kamera befinden. Die Sichtbereiche der Kameras liegen zwischen 10 $\mu$m und 50mm, vorzugsweise zwischen 50$\mu$m und 25mm, noch bevorzugter zwischen 100$\mu$m und 15mm, am bevorzugtesten zwischen 250$\mu$m und 10mm, am allerbevorzugtesten zwischen 300$\mu$m und 5mm.

In einem zweiten erfindungsgemäßen Prozessschritt erfolgt eine Änderung des unteren und/oder oberen optischen Teilsystems, sodass zumindest beide projizierten Ausrichtungsmarken sich im Sichtbereich der oberen Kamera befinden. Unter einer Änderung des unteren und/oder oberen optischen Teilsystems versteht man insbesondere die translatorische und/oder rotatorische und/oder funktionale Änderung mindestens eines optischen Elements im unteren und/oder oberen optischen Teilsystem. Insbesondere versteht man dabei eine translatorische und/oder rotatorische Bewegung der unteren und/oder oberen Optik.

In einem dritten erfindungsgemäßen Prozessschritt erfolgt ein Keilfehlerausgleich zwischen den beiden optischen Ebenen, bzw. eine Verminderung des Winkels zwischen den optischen Achsen. Der Keilfehlerausgleich wird so durchgeführt, dass mindestens ein optisches Element im unteren und/oder oberen optischen Teilsystem so verändert wird, dass es zu einer Verminderung der Inklination zwischen den beiden optischen Achsen der beiden optischen Teilsysteme kommt. Insbesondere wird der Keilfehler durch die Rotation mindestens einer der beiden Optiken reduziert.

In einem vierten erfindungsgemäßen Prozessschritt, nachdem sich alle Ausrichtungsmarken im Schärfentiefebereich und im Sichtbereich des oberen Kamerachips befinden und der Keilfehler weitestgehend reduziert wurde, erfolgt eine Feinjustierung zwischen den Ausrichtungsmarken, indem die projizierten Ausrichtungsmarken am oberen Kamerachip in die Position der idealen Positionen gebracht werden. Dies erfolgt insbesondere durch translatorische Verschiebung und/oder Drehung der unteren und/oder oberen Optik.

Insbesondere können die erfindungsgemäßen Prozessschritte eins bis vier in beliebiger Reihenfolge und/oder gleichzeitig erfolgen. Eine insbesondere gleichzeitige Ausführung aller erfindungsgemäßen Prozessschritte wird durch eine entsprechende Firm- und/oder Hard- und/oder Software sichergestellt, die die beiden optischen Teilsysteme, insbesondere vollautomatisch durch einen Algorithmus, zueinander kalibrieren kann. Insbesondere kann die Kalibrierung durch eine Regelschleife automatisch erfolgen.

Die erfindungsgemäßen Prozessschritte eins bis drei sind insbesondere Prozessschritte einer Grobkalibrierung, die nur sehr selten, insbesondere nach einer Wartung, einem Aufbau oder einem Platzwechsel der erfindungsgemäßen Ausführungsform vollständig durchgeführt werden müssen. Nach einer durchgeführten Grobkalibrierung ist meistens für längere Zeit nur mehr eine Feinkalibrierung gemäß Prozessschritt vier notwendig.

Das erfindungsgemäß kalibrierte optische System kann danach zur Vermessung von Oberflächen verwendet werden. Insbesondere eignet sich das System zur Ausrichtung zweier Substrate zueinander. In einer ganz besonders bevorzugten Ausführungsform wird das System zur face-to-face Ausrichtung zweier Substrate zueinander verwendet.

Eine weitere Möglichkeit zur Verwendung des erfindungsgemäß kalibrierten optischen Systems besteht in der Vermessung der Ober- und Unterseite eines Substrats- oder Substratstapels. Das optische System wird in diesem speziellen Fall als Teil eines Messsystems (engl.: metrology tool) verwendet. Die gleichzeitige Vermessung der Ober- und Unterseite eines Substrats- oder Substratstapels wird meistens durchgeführt um einen horizontalen Abstand zwischen zwei Oberflächenmerkmalen zu vermessen.

Kamerachip

Der Kamerachip ist insbesondere als Flächendetektor ausgebildet. Vorzugsweise handelt es sich bei dem Kamerachip um einen CCD-Detektor, einen CMOS Detektor, einen Analogdetektor, einen Vierquadrantendetektor oder ein sogenanntes Position Sensing Device (PSD). Der Kamerachip weist insbesondere eine Auslesefrequenz zwischen 1 Hz und 1 MHz, vorzugsweise zwischen 10 Hz und 100000 Hz, noch bevorzugter zwischen 20 Hz und 10.000 Hz, am bevorzugtesten zwischen 30 Hz und 1000 Hz, am allerbevorzugtesten zwischen 40 und 100 Hz auf. Unter Auslesefrequenz versteht man hierbei die Anzahl der vollen Interferenzbilder, die der Kamerachip pro Sekunde auslesen kann.

Die horizontale Pixelauflösung des Kamerachips beträgt insbesondere mehr als 10 Pixel/cm, vorzugsweise mehr als 100 Pixel/cm, noch bevorzugter mehr als 1000 Pixel/cm, am bevorzugtesten mehr als 10000 Pixel/cm, am allerbevorzugtesten mehr als 100000 Pixel/cm.

Die vertikale Pixelauflösung des Kamerachips beträgt insbesondere mehr als 10 Pixel/cm, vorzugsweise mehr als 100 Pixel/cm, noch bevorzugter mehr als 1000 Pixel/cm, am bevorzugtesten mehr als 10000 Pixel/cm, am allerbevorzugtesten mehr als 100000 Pixel/cm.

Der Abstand zwischen zwei Pixeln liegt zwischen 0.1 $\mu$m und 100 $\mu$m, vorzugsweise zwischen 0.5 $\mu$m und 50 $\mu$m, noch bevorzugter zwischen 1 $\mu$m und 25 $\mu$m, am bevorzugtesten zwischen 2.5 $\mu$m und 10 $\mu$m, am allerbevorzugtesten bei 5 $\mu$m.

In einer besonderen erfindungsmäßen Ausführungsform kann das optische System über zwei Kameras mit zwei unterschiedlichen Kamerachips verfügen. Die Kamerachips könnten sich beispielsweise in ihrer Größe unterscheiden. In diesem Fall kann sogar auf die Verwendung von Ausrichtungsmarken verzichtet werden. Die erfindungsgemäße Kalibrierung erfolgt dann dahingehend, dass die Konturen eines Kamerachips auf den jeweils anderen Kamerachip projiziert werden. Durch optische Elemente, die eine Skalierung ermöglichen, kann der zu projizierende Kamerachips deckungsgleich auf die Oberfläche des anderen Kamerachips abgebildet werden. Im Allgemeinen findet also eine affine Transformation des einen Kamerachips auf den anderen Kamerachip statt, die sich dadurch auszeichnet, dass die Flächen der Kamerachips deckungsgleich sind. Eine solche affine Transformation ist immer durch die mathematischen Operationen Verschiebung, Drehung und Skalierung erreichbar, die im optischen System durch die optischen Elemente realphysikalisch umgesetzt wird. Die beiden unterschiedlich großen Chips haben vorzugsweise die gleiche Pixelgröße und/oder gleiche Pixelauflösung, d.h. den gleichen Abstand zwischen den Pixeln. Diese erfindungsgemäße Ausführungsform ist besonders bevorzugt, da hier nicht einmal Ausrichtungsmarken auf die Chipoberflächen projiziert werden müssen, bzw. die Konturen der Kamerachips als Ausrichtungsmarken angesehen werden können. Der Chip, insbesondere seine Kontur, selbst ist die Ausrichtungsmarke, was zu einer weiteren Kostenersparnis beim Bau der erfindungsgemäßen Vorrichtung führt, da kein Ausrichtungsmarkenprojektionssystem benötigt wird. Des Weiteren wird die erfindungsgemäße Vorrichtung damit auch völlig unabhängig vom Chiphersteller, da dieser keine Ausrichtungsmarken vorsehen muss, die Kontur eines Chips aber ein immanenter Anteil seines Aufbaus ist. Wird die Kontur eines Chips als Ausrichtungsmarke verwendet, ist der Chips durch die optischen Systeme möglichst zentriert zu erfassen, d.h. der Schwerpunkt des Chips sollte möglichst nahe an der optischen Achse liegen. Insbesondere ist der Abstand zwischen der optischen Achse und dem Schwerpunkt des Chips kleiner als 1mm, vorzugsweise kleiner als 0.5 mm, noch bevorzugter kleiner als 0.1 mm, am bevorzugtesten kleiner als 0.01 mm, am allerbevorzugtesten kleiner als 0.001 mm.

Für alle genannten erfindungsgemäßen Ausführungsformen der Kalibrierung zweier optischer Teilsysteme zueinander gilt, dass in der Praxis eine perfekte Kalibrierung entweder nicht möglich oder, insbesondere aus wirtschaftlichen Gründen, nicht erwünscht ist. Eine extrem genaue Kalibrierung kann eine beträchtliche Zeitspanne dauern, während der weitere Prozesse, die mit der Anlage durchgeführt werden, nicht stattfinden können. Im Allgemeinen kann ein Kalibrierungsprozess abgebrochen werden, sobald ein festgelegter Grenzwert erreicht bzw. überschritten wurde. In einer weiteren erfindungsgemäßen Erweiterung ist es denkbar, dass die Koordinaten der beiden nicht perfekt zueinander kalibrierten Ausrichtungsmarken in Bezug zu einem gemeinsamen Koordinatensystem gespeichert werden. Bei diesem gemeinsamen Koordinatensystem kann es sich beispielsweise um das untere Detektorkoordinatensystem oder das obere Detektorkoordinatensystem handeln. Denkbar ist auch, dass die Koordinaten der beiden nicht perfekt zueinander kalibrierten Ausrichtungsmarken in einem beliebigen anderen Koordinatensystem gespeichert werden. Durch die nicht zustande kommende und/oder nicht erwünschte perfekte Überlagerung der Ausrichtungsmarken sind die Ausrichtungsmarken daher nach dem Kalibrierprozess im Allgemeinen noch ein wenig zueinander verschoben und/oder zueinander verdreht. Dieser Verschiebung und/oder Verdrehung zueinander kann vermessen, gespeichert und in einem späteren Prozess, insbesondere einem Ausrichtungsprozess zweier Substrate zueinander (engl: alignment), verwendet werden, um eine Korrektur der ermittelten Koordinaten von Ausrichtungsmarken auf den Substraten durchzuführen.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:

Figur 1a    eine schematische, nicht maßstabsgetreue Skizze eines ersten erfindungsgemäßen optischen Systems mit einer ersten Lichteinkopplung,

Figur 1b    eine schematische, nicht maßstabsgetreue Skizze eines zweiten erfindungsgemäßen optischen Systems mit einer zweiten Lichteinkopplung,

Figur 1c    eine schematische, nicht maßstabsgetreue Skizze eines dritten erfindungsgemäßen optischen Systems mit einer dritten Lichteinkopplung,

Figur 2a    eine schematische, nicht maßstabsgetreue vereinfachte Skizze eines erfindungsgemäß ersten Prozessschrittes,

Figur 2b    eine schematische, nicht maßstabsgetreue vereinfachte Skizze eines erfindungsgemäß zweiten Prozessschrittes,

Figur 2c    eine schematische, nicht maßstabsgetreue vereinfachte Skizze eines erfindungsgemäß dritten Prozessschrittes,

Figur 2d    eine schematische, nicht maßstabsgetreue vereinfachte Skizze eines erfindungsgemäß vierten Prozessschrittes,

Figur 3a    eine schematische, nicht maßstabsgetreue vereinfachte, vergrößerte Skizze einer unteren sensitiven Oberfläche,

Figur 3b    eine schematische, nicht maßstabsgetreue vereinfachte, vergrößerte Skizze eines erfindungsgemäß vierten Prozessschrittes im Anfangszustand,

Figur 3c    eine schematische, nicht maßstabsgetreue vereinfachte, vergrößerte Skizze eines erfindungsgemäß vierten Prozessschrittes im Endzustand,

Figur 4a    eine schematische, nicht maßstabsgetreue vereinfachte isometrische Explosionsskizze eines erfindungsgemäßen ersten Kamerachips und

Figur 4b    eine schematische, nicht maßstabsgetreue vereinfachte isometrische Explosionsskizze eines erfindungsgemäßen zweiten Kamerachips.

In den Figuren sind gleiche Bauteile oder Bauteile mit der gleichen Funktion mit den gleichen Bezugszeichen gekennzeichnet.

In den dargestellten Figuren sind alle optischen Pfade 7, 7', 8 lediglich schematisch dargestellt und nicht als den Gesetzen der Optik streng entsprechende Pfade zu verstehen. Des Weiteren werden die optischen Pfade 7, 7', 8 und die optischen Teilsysteme 12u, 12u' ,12u" ,12o ,12o' ,12o" so dargestellt, dass keine wechselseitige, spiegelbildliche Projektion Kamerachips 2u, 2o erfolgt. Dadurch wird insbesondere das Verständnis der Deckungsgleichen Detektorkoordinatensysteme erleichtert. Dem Fachmann auf dem Gebiet ist klar, dass in einer realen Ausführungsform die wechselseitige Abbildung der Kamerachips 2u, 2o aufeinander spiegelbildlich erfolgen kann und bevorzugt auch spiegelbildlich erfolgt.

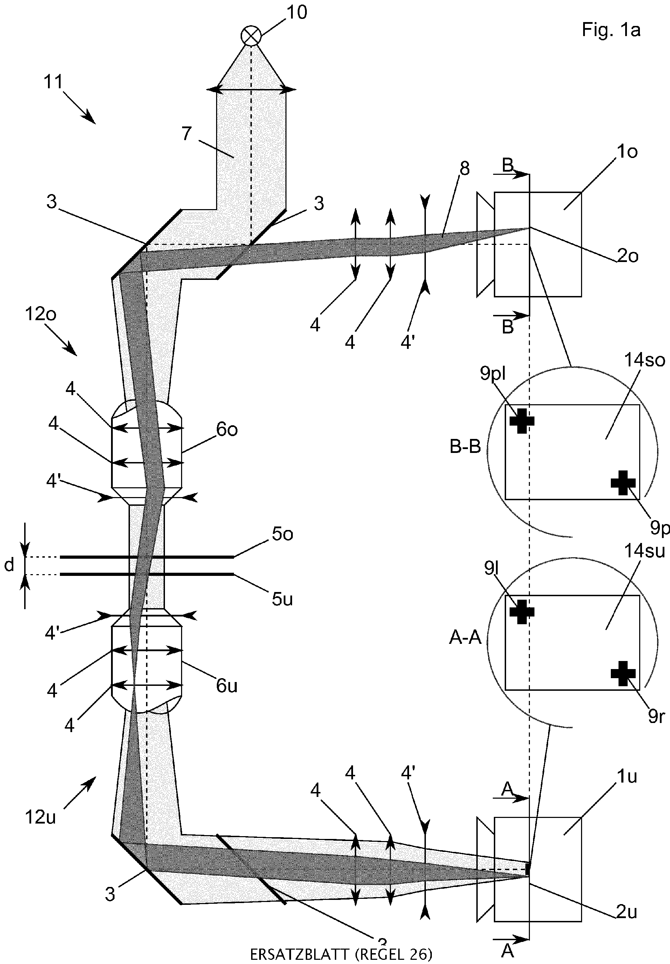

Die Figur 1a zeigt eine schematische, nicht maßstabsgetreue Skizze eines ersten erfindungsgemäßen optischen Systems 11, aufweisend zwei optische Teilsysteme 12u, 12o mit zwei Lichtpfaden 7,8. Der Lichtpfad 7 stellt einen Beleuchtungspfad für einen unteren Kamerachip 2u einer unteren Kamera 1u dar. Der Lichtpfad 8 ist der Abbildungspfad der Ausrichtungsmarken 9l,9r.

Das optische System 11 weist mehrere Spiegel 3 und optische Elemente 4,4' auf, wie z.B. Spiegel, Linsen, Prismen etc. Von einer Lichtquelle 10 wird Licht 7 in das optische System 11 eingekoppelt. Das Licht 7 durchläuft das optische System 11 mit den Spiegeln 3 und optischen Elementen 4,4' und tritt aus dem optischen System 11 wieder aus, wobei es auf eine photosensitive Oberfläche 14su des unteren Kamerachips 2u der unteren Kamera 1u trifft.

In dieser ersten erfindungsgemäßen Ausführungsform wird das Licht des Beleuchtungspfads 7 über die Quelle 10, insbesondere eine Lampe, noch bevorzugter eine Halogenlampe, und einen Spiegel 3 in das optische System 11 eingekoppelt. Das Licht des Beleuchtungspfads 7 durchdringt zwei Optiken 6o, 6u und wird über weitere optische Elemente, insbesondere weitere Spiegel 3, auf den Kamerachip 2u der unteren Kamera 1u projiziert.

Die Einkoppelung des Lichts in das optische System 11 ist selbstverständlich auch von jedem anderen Spiegel 3 im optischen System 11 denkbar, insbesondere wenn es darum geht, einen Kamerachip 2o einer oberen Kamera 1o intensiv zu beleuchten. Denkbar ist auch die Einkoppelung von Licht über mehrere Quellen 10 und mehrere Spiegel 3 in das optische System 11.

Die Figur 1a stellt auch den Abbildungspfad 8 dar, welcher die Oberfläche des Kamerachips 2u bzw. dessen Umgebung über optische Elemente 4, 4', 3 auf den Kamerachip 2o abbildet. In diesem konkreten Fall stellt der Kamerachip 2u die Gegenstandsebene und der Kamerachip 2o die Bildebene des gesamten optischen Systems 11 dar. In der Schnittansicht A-A erkennt man zwei Ausrichtungsmarken 9l, 9r.

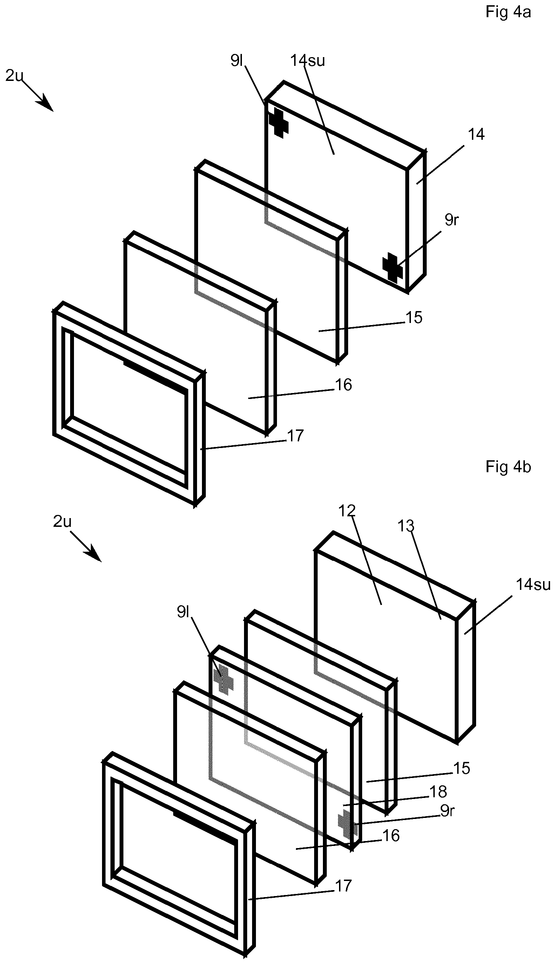

In der ersten erfindungsgemäßen Ausführungsform handelt es sich dabei z.B. um Ausrichtungsmarken 9l, 9r gemäß Figur 4a, die direkt auf der photosensitiven Oberfläche 14su des unteren Kamerachips 2u aufgebracht wurden. Bei den Ausrichtungsmarken 91, 9r handelt es sich dann vorzugsweise um eine, insbesondere in Kreuzform hergestellte, Ansammlung nicht funktionsfähiger Pixel. Diese Pixel sind nicht funktionsfähig, weil sie beschichtet wurden, nicht verbunden wurden, zerstört wurden, inaktiviert wurden etc.

Denkbar ist auch, dass es sich um Ausrichtungsmarken 91, 9r gemäß Figur 4b handelt. In diesem Fall befinden sich die Ausrichtungsmarken 91, 9r nicht direkt auf der photosensitiven Oberfläche 14su des unteren Kamerachips 2u, aber zumindest in dessen Nähe. Auf alle Fälle sind die Ausrichtungsmarken 91,9r reale physikalische Entitäten.

Die Ausrichtungsmarken 91,9r werden nun über den Abbildungspfad 8 auf den oberen Kamerachip 2o projiziert und ergeben so projizierte Ausrichtungsmarken 9pl, 9pr auf der photosensitiven Oberfläche 14so des oberen Kamerachips 2o. In der Figur 1a sind die Kameras 1u, 1o bzw. die optischen Elemente im Projektionspfad 8 bereits perfekt zueinander kalibriert, sodass die projizierten Ausrichtungsmarken 9pl, 9pr im Schnitt B-B an den korrekten, idealen Positionen scharf erscheinen. Insbesondere erkennt man, dass die Bildebene 5u des unteren optischen Teilsystems 12u und die Gegenstandsebene 5o des oberen optischen Teilsystems 12o in einem Abstand d zueinander stehen. Der Abstand d wurde der Übersichtlichkeit halber groß genug gewählt, um die Bildebene 5u sowie die Gegenstandsebene 5o deutlich voneinander unterscheiden zu können. Zur Erzeugung scharfer projizierter Ausrichtungsmarken 9pl, 9pr müssen die Bildebene 5u sowie die Gegenstandsebene 5o jeweils im Schärfentiefebereich der jeweils anderen Eben liegen.

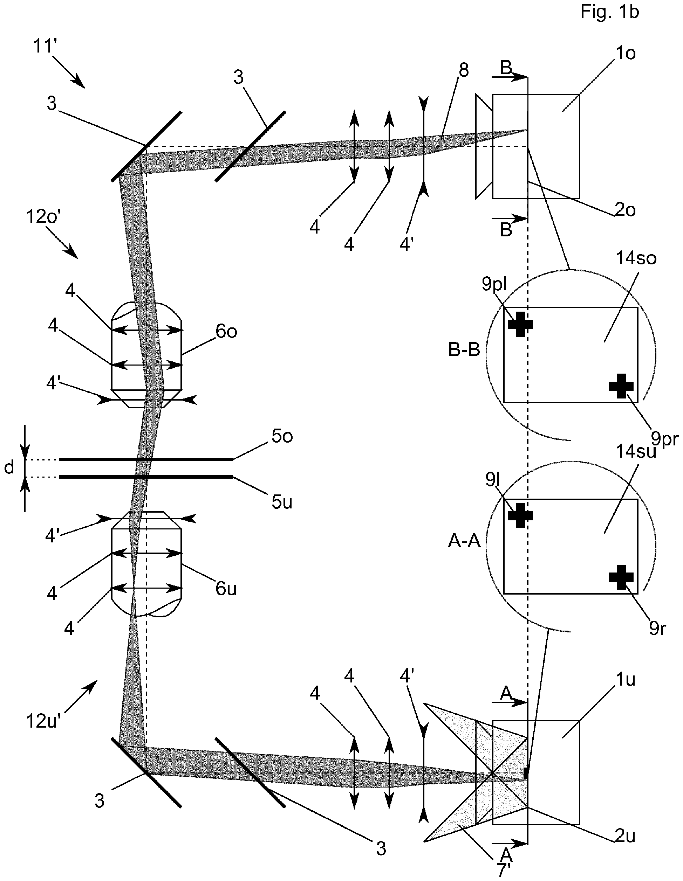

Die Figur 1b zeigt eine schematische, nicht maßstabsgetreue Skizze eines zweiten erfindungsgemäßen optischen Systems 11', aufweisend zwei optische Teilsysteme 12u', 12o' mit zwei Lichtpfaden 7',8. Der Lichtpfad 7' stellt den Beleuchtungspfad für den unteren Kamerachip 2u der unteren Kamera 1u dar. In dieser erfindungsgemäßen Ausführungsform wird das Licht des Beleuchtungspfad 7' nicht über eine Quelle 10 sondern einfach aus der Umgebung, insbesondere direkt, in das optische System 11' eingekoppelt. Es handelt sich also um Streulicht, dem Zugang zum optischen System 11' gewährt wird, indem, insbesondere an mindestens einer Stelle, noch bevorzugter an der Kamera 1u, entsprechende Abschirmungen des optischen Systems 11' absichtlich nicht verbaut werden. Die Einkoppelung des Lichts in das optische System 11' ist auch von jeder anderen Stelle im optischen System 11', insbesondere an den Spiegeln 3, denkbar. Denkbar ist auch die Einkoppelung von Licht an mehreren Stellen des optischen Systems 11'. Alternativ könnte in der Umgebung der Kamera eine Beleuchtung, mit Vorzug mit LEDs als Lichtquellen, vorgesehen sein.

Die Figur 1b stellt auch den Abbildungspfad 8 dar, welcher die Oberfläche des Kamerachips 2u bzw. dessen Umgebung über optische Elemente 4, 4', 3 auf den Kamerachip 2o abbildet. In diesem konkreten Fall stellt der Kamerachip 2u die Gegenstandsebene und der Kamerachip 2o die Bildebene dar. Die Schnitte A-A und B-B zeigen, wie bereits in der Figur 1a beschrieben, eine optimale Abbildungssituation.

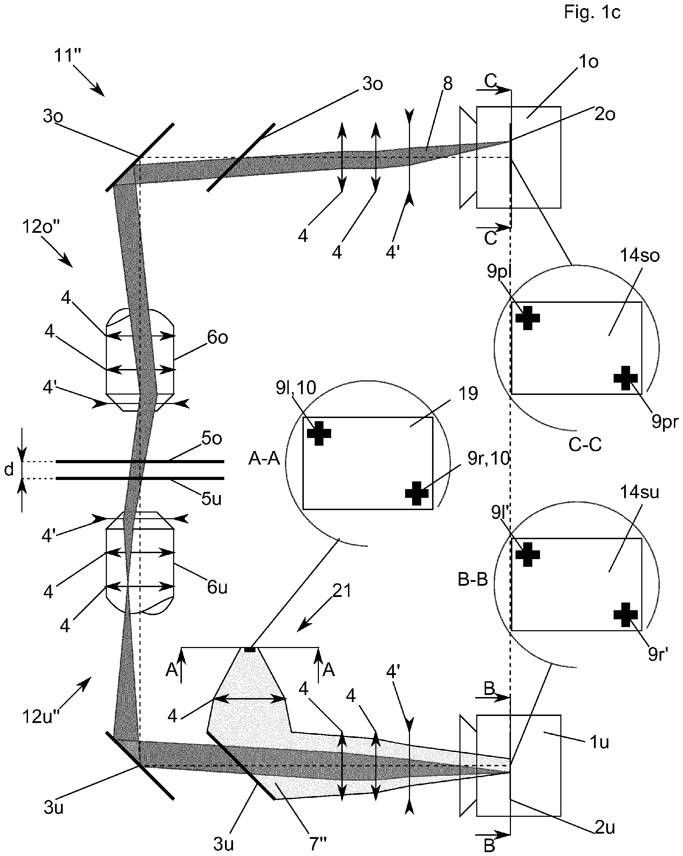

Die Figur 1c zeigt eine schematische, nicht maßstabsgetreue Skizze eines optischen Systems 11", bestehend aus zwei optischen Teilsystemen 12u", 12o" mit zwei Lichtpfaden 7",8.

Der Lichtpfad 7" wird in einer ersten erfindungsgemäßen Ausführungsform von Ausrichtungsmarken 91, 9r auf einer Oberfläche 19 erzeugt, wobei die Ausrichtungsmarken 91, 9r gleichzeitig auch als Lichtquellen 10 fungieren (Ansicht A-A). Denkbar wäre beispielsweise, dass die Ausrichtungsmarken 9l, 9r aus einem, insbesondere kreuzförmiges, LED Feld bestehen.

In einer weiteren, zweiten erfindungsgemäßen Ausführungsform strahlt die Oberfläche 19, auf der sich die Ausrichtungsmarken 91, 9r befinden, Licht aus und die Ausrichtungsmarken 91, 9r fungieren nicht als aktive Lichtquellen 10 sondern nur als Masken. Dann würden die Ausrichtungsmarken 91, 9r als Schattenmarken über den Beleuchtungspfad 7" projiziert werden.

Die erfindungsgemäße Ausführungsform projiziert die Ausrichtungsmarken 9l, 9r der Oberfläche 19 auf den Kamerachip 2u (Ansicht B-B). Die photosensitive Oberfläche 14su des Kamerachips 2u stellt wiederum die Gegenstandsebene für die Kamera 1o dar. Die von einem Ausrichtungsmarkenprojektionssystem 21 projizierten Ausrichtungsmarken 91', 9r' werden also über das optische System 11", als Ausrichtungsmarken 9pl, 9pr, auf die photosensitive Oberfläche 14so des oberen Kamerachips 2o der oberen Kamera 1o projiziert.

Der Unterschied zu den Ausführungsformen gemäß den Figuren 1a und 1b besteht darin, dass keiner der beiden Kamerachips 2u, 2o selbst über Ausrichtungsmarken 91, 9r verfügen muss, sondern dass diese über das erfindungsgemäße Ausrichtungsmarkenprojektionssystem 21, als projizierte Ausrichtungsmarken 91' und 9r', auf die photosensitive Fläche 2u der unteren Kamera 1u projiziert, und somit in das optische System 11" eingebracht werden.

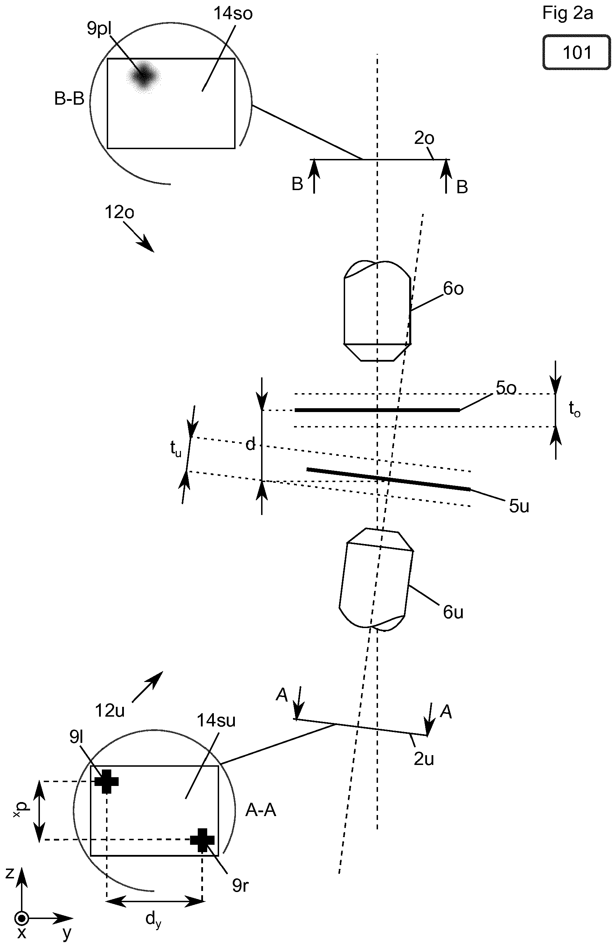

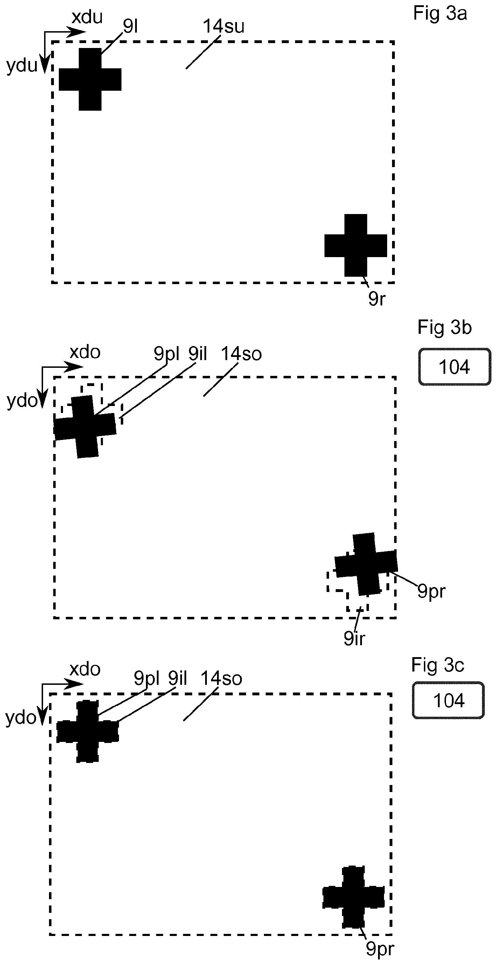

Die Darstellungen in den Figuren 1a-1c sind dahingehend ideal, dass die optischen Elemente 3, 3o, 3u, 4, 4', 6u, 6o, 1u, 1o bereits perfekt zueinander ausgerichtet worden sind. In den weiteren Figuren 2a-2d sowie in den Figuren 3a, 3b werden die einzelnen Prozessschritte erläutert, die durchgeführt werden müssen, um diesen idealen Zustand zu erreichen und das optische System 11, 11', 11" zu kalibrieren. Insbesondere wird, aufgrund der Übersichtlichkeit, auf die Darstellung der Lichtpfade, insbesondere des Beleuchtungspfades 7, 7' und des Abbildungspfades 8, und der optischen Elemente weitestgehend verzichtet. Die Figuren 2a-2d stellen exemplarisch und stellvertretend ein optisches System 11 gemäß Figur 1a dar. Die Figur 2a zeigt eine schematische, nicht maßstabsgetreue, vereinfachte Skizze des erfindungsgemäßen optischen Systems 11 in einem ersten erfindungsgemäßen Prozessschritt 101, bestehend aus den zwei optischen Teilsystemen 12u, 12o, gemäß Figur 1a. Das charakteristische Merkmal dieser Darstellung besteht vor allem in einem Abstand d zwischen der unteren Bildebene (auch optische Ebene genannt) 5u der unteren Optik 6u und der oberen Bildebene 5o der oberen Optik 6o.

Die Ausrichtungsmarken 9l,9r befinden sich auf der photosensitiven Oberfläche 14su in einem Abstand dx in X-Richtung zueinander und in einem Abstand dy in Y-Richtung.

Der Abstand d zwischen den optischen Ebenen 5u und 5o ist so groß, dass die obere optische Ebene 5o den unteren Schärfentiefebereich tu der unteren optischen Ebene 5u nicht schneidet bzw. die untere optische Ebene 5u den oberen Schärfentiefebereich to der oberen optischen Ebene 5o nicht schneidet. Die optische Ebene 5u ist die Bildebene des unteren optischen Teilsystems 12u.

Die in die Bildebene 5u projizierten Ausrichtungsmarken 9l,9r müssen aber über das obere optische Teilsystem 12o auf die photosensitive Oberfläche 14so des oberen Kamerachips 2o projiziert werden. Um die in die Bildebene 5u des unteren optischen Systems 12u projizierten Ausrichtungsmarken 9l,9r allerdings scharf auf die photosensitive Oberfläche 14so abbilden zu können, muss die optische Ebene 5u im Schärfentiefebereich to der oberen optischen Ebene 5o liegen, die gleichzeitig die Gegenstandsebene für das obere optische Teilsystem 12o darstellt. Ist das nicht der Fall, so wie in der Figur 2a gezeigt, werden die projizierten Ausrichtungsmarken 9pl, 9pr auf der photosensitiven Oberfläche 14so unscharf abgebildet (Darstellung B-B). Der Prozessschritt der Figur 2a besteht also darin, die beiden optischen Ebenen 5u und 5o aneinander anzunähern.

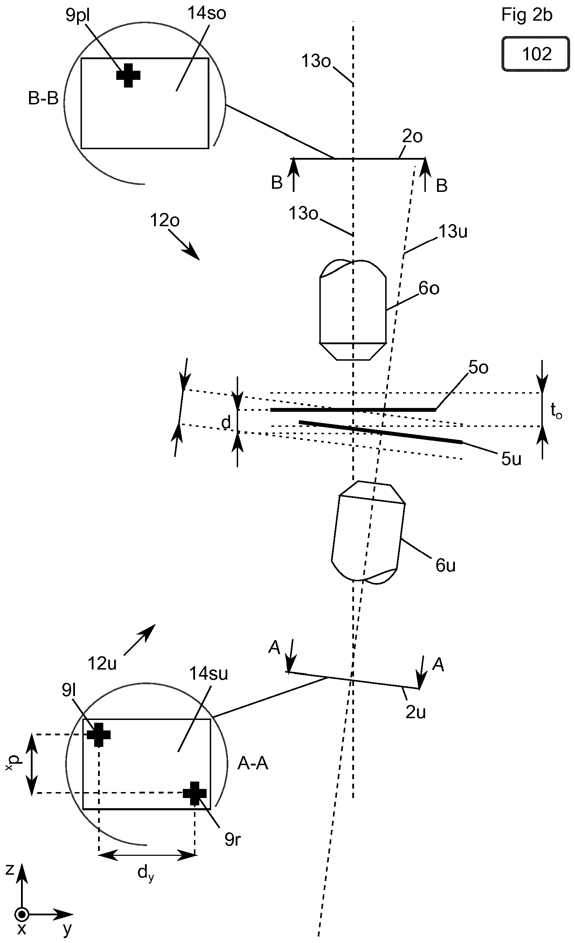

Die Figur 2b zeigt eine schematische, nicht maßstabsgetreue, vereinfachte Skizze des optischen Systems 11in einem zweiten erfindungsgemäßen Prozessschritt 102, bestehend aus den zwei optischen Teilsystemen 12u, 12o, bei dem die optischen Ebenen 5u und 5o weitgehend aneinander angenähert wurden, während die optischen Achsen 13u und 13o der Optiken 6u und 6o so stark zueinander verschoben sind, dass sie sich nicht zwischen den Optiken 6u, 6o schneiden.

Diese große Abweichung der optischen Achsen 13u, 13o führt dazu, dass nur die Ausrichtungsmarke 9pl sich im Sichtbereich der oberen Kamera 1u befindet (Darstellung B-B). Diese wird scharf abgebildet, da sich der Teil der optischen Ebene 5u, auf den die Ausrichtungsmarke 9l zwischenprojiziert wird, im Schärfentiefebereich to der oberen optischen Ebene 5o befindet.

Die Verschiebung der optischen Achsen 13u und 13o zueinander resultiert in einer Verschiebung der projizierten Abbildung mit den Ausrichtungsmarken 9pl und 9pr auf der oberen photosensitiven Oberfläche 14so des oberen Kamerachips 2o. Diese Verschiebung kann so stark sein, dass eine der Ausrichtungsmarken 9pl, 9pr nicht sichtbar ist, da sie nicht auf die photosensitiven Oberfläche 14so projiziert wird. Im vorliegenden Fall handelt es sich dabei um die Ausrichtungsmarke 9pr. Der Prozessschritt der Figur 2b besteht also darin, die beiden Ausrichtungsmarken 9pl, 9pr in den Sichtbereich der oberen Kamera 1o zu bringen.

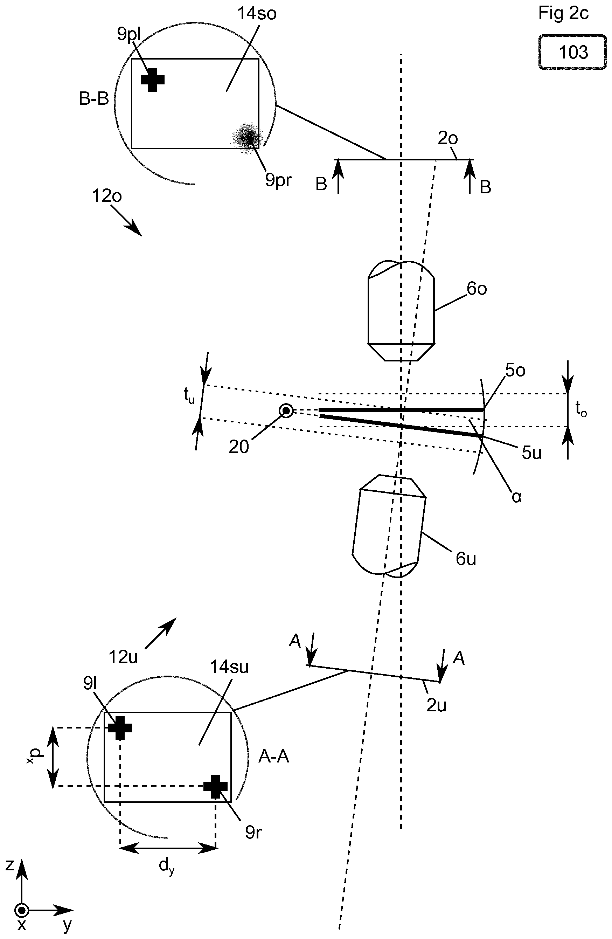

Die Figur 2c zeigt eine schematische, nicht maßstabsgetreue, vereinfachte Skizze des optischen Systems 11 in einem dritten erfindungsgemäßen Prozessschritt 103, bestehend aus den zwei optischen Teilsystemen 12u, 12o, bei dem sich zwar die beiden projizierten Ausrichtungsmarken 9pl, 9pr im Sichtbereich der oberen Kamera 1o befinden, die beiden optischen Ebenen 5u und 5o allerdings noch immer stark zueinander geneigt sind. Ein Teil der unteren optischen Ebene 5u befindet sich dabei im oberen Schärfentiefebereich to der oberen optischen Ebene 5o, während der andere Teil sich außerhalb befindet.

In Analogiebetrachtung zur Beschreibung der Figur 2b folgt daher, dass die Ausrichtungsmarke 9l scharf als Ausrichtungsmarke 9pl abgebildet wird, während die Ausrichtungsmarke 9r als Ausrichtungsmarke 9pr unscharf abgebildet wird. Durch eine entsprechende Bewegung des unteren optischen Teilsystems 12u und/oder des oberen optischen Teilsystems 12o, insbesondere der Optiken 6u, 6o, können die optischen Ebenen 5u und 5o so zueinander ausgerichtet werden, dass die projizierten Ausrichtungsmarken 9pl und 9pr beide scharf dargestellt werden.

Aus dem Gesagten lässt sich mathematisch ableiten, wie man den minimalen Keilfehler, der gerade noch mit der erfindungsgemäßen Methode messbar und damit einstellbar ist, berechnen kann. Für die Berechnung wird der Einfachheit halber angenommen, dass die beiden optischen Ebenen 5u, 5o ausschließlich um eine Kippachse 20, die parallel zur x-Achse liegt, gekippt sind. Es sei to die Schärfentiefe der oberen optischen Ebene 5o und dx der Abstand zwischen den Ausrichtungsmarken 9l, 9r. Dann gilt

$$\tan\alpha = \frac{t_o}{d_x}$$

Der minimale korrigierbare Keilfehler beträgt daher

$$\alpha = \arctan\frac{t_o}{d_x}$$

Man erkennt, dass der korrigierbare Keilfehler umso kleiner ist, je größer der Abstand dx zwischen den Ausrichtungsmarken 9l, 9r und desto kleiner der Schärfentiefebereich to der oberen optischen Ebene 5o ist. Der Prozessschritt der Figur 2c besteht also darin, den Keilfehler zwischen den beiden optischen Ebene 5u, 5o weitestgehend zu minimieren.

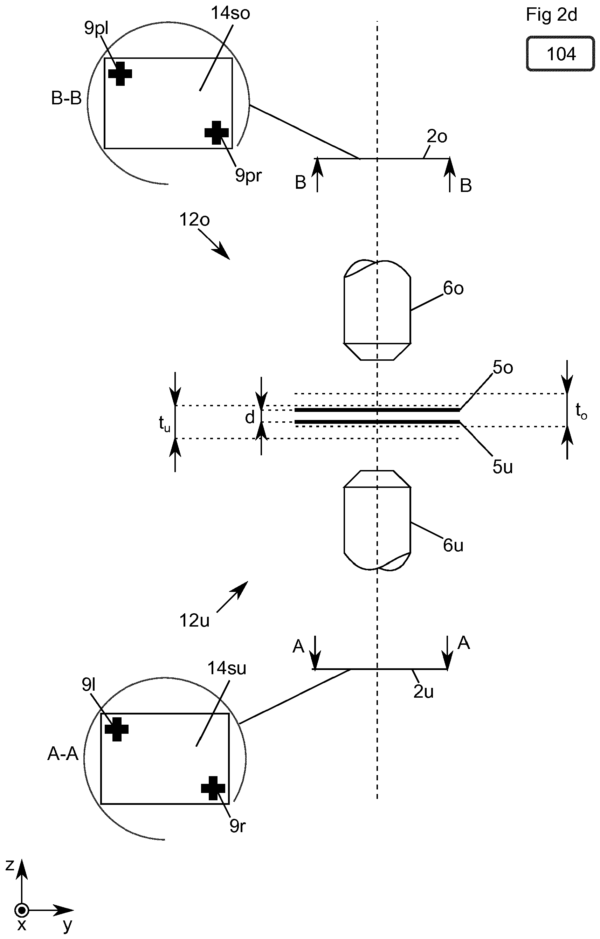

Die Figur 2d zeigt eine schematische, nicht maßstabsgetreue, vereinfachte Skizze des optischen Systems 11 in einem vierten erfindungsgemäßen Prozessschritt 104, bestehend aus den zwei optischen Teilsystemen 12u, 12o, in einem optimalen Zustand, bei dem sich die optische Ebene 5u, welche die Bildebene für die projizierten Ausrichtungsmarken 9l und 9r darstellt, im Schärfentiefebereich to der oberen optischen Ebene 5o befindet, die gleichzeit als Gegenstandsebene für das obere optische Teilsystem 12o und damit die projizierten Ausrichtungsmarken 9pl und 9pr dient. Vorzugsweise sind die beiden Ebenen 5u und 5o parallel zueinander. In der Realität werden die beiden Ebenen aber immer einen nicht verschwindenden Winkel zueinander aufweisen. Der Winkel zwischen den beiden Ebenen 5u und 5o ist dabei kleiner als 5°, vorzugsweise kleiner als 1°, noch bevorzugter kleiner als 0.1°, am bevorzugtesten kleiner als 0.01°, am allerbevorzugtesten kleiner als 0.001°. Der Fachmann weiß, dass der Winkel zwischen zwei Ebenen identisch ist zum Winkel zwischen den beiden Ebenennormalen.

Da sich die untere optische Ebene 5u im Schärfentiefebereich to der oberen optischen Ebene befindet, werden die Ausrichtungsmarken 9l und 9r als scharfe Ausrichtungsmarken 9pl und 9pr abgebildet (siehe Darstellung B-B).

In diesem Prozessschritt erfolgt nun noch die Feinkalibrierung der Ausrichtungsmarken 9pl, 9pr in Bezug zu gewünschten, idealen Positionen 9il, 9ir (siehe Fig. 3b). Der Prozessschritt der Figur 2d besteht also darin, die Feinkalibrierung der Ausrichtungsmarken 9pl, 9pr, insbesondere in x- und/oder y-Richtung, durchzuführen.

Die Figur 3a zeigt eine schematische, nicht maßstabsgetreue, vereinfachte, vergrößerte Skizze des photosensitiven Bereichs 14su des unteren Kamerachips 2u. Man erkennt die entsprechenden Ausrichtungsmarken 9l, 9r. Die Position der Ausrichtungsmarken 9l, 9r lässt sich am besten in Bezug zu einem unteren Detektorkoordinatensystem (xdu, ydu) angeben. Der Ursprung des unteren Detektorkoordinatensystems (xdu, ydu) liegt beispielsweise in der linken oberen Ecke der photosensitiven Oberfläche 14su.

Die Figur 3b zeigt eine schematische, nicht maßstabsgetreue, vereinfachte, vergrößerte Skizze des photosensitiven Bereichs 14so des oberen Kamerachips 2o am Beginn des vierten erfindungsgemäßen Prozessschritts 104.

Erkennbar ist, dass die projizierten Ausrichtungsmarken 9pl, 9pr nicht deckungsgleich zu den idealen Positionen 9il, 9ir sind. Die obere photosensitive Oberfläche 14so besitzt ein oberes Detektorkoordinatensystem (xdo, ydo). Der Ursprung des oberen Detektorkoordinatensystems (xdo, ydo) liegt in der linken oberen Ecke der photosensitiven Oberfläche 14so.

Die Koordinaten der idealen Positionen 9il, 9ir im Detektorkoordinatensystem (xdo, ydo) entsprechen vorzugsweise den Koordinaten der Ausrichtungsmarken 9l, 9r im unteren Detektorkoordinatensystem (xdu, ydu), sofern die photosensitiven Bereich 14su, 14so über die gleichen Eigenschaften wie Länge, Breite, Auflösung in x-Richtung, Auflösung in y-Richtung etc. verfügen, oder kurz gesagt, die gleichen Kamerachips 2u, 2o verwendet werden. Eine weitere Bedingung ist natürlich die korrekte und immer gleiche Wahl des Ursprungs der Detektorkoordinatensysteme (xdu, ydu) und (xdo, ydo).

Durch eine weitere Anpassung der optischen Elemente in den optischen Systemen 11, 11', 11'' können die Ausrichtungsmarken 9pl, 9pr in Bezug zu den idealen Positionen 9il, 9ir kalibriert werden. Dabei kann es zu translatorischen Verschiebungen der Ausrichtungsmarken 9pl, 9pr und/oder zu einer Rotation in Bezug zum Detektorkoordinatensystem (xdo, ydo) kommen.

Ist eine perfekte Kalibrierung nicht vollständig möglich und/oder wirtschaftlich nicht erwünscht, da sie zu lange dauern würde, werden die Ausrichtungsmarken 9pl, 9il bzw. 9pr, 9ir nicht vollständig miteinander zur Deckung kommen sondern zueinander translatorisch und/oder rotatorisch verschoben sein. Der Ausrichtungsprozess würde dann an diesem Schritt enden. Erfindungsgemäß speichert das System die Koordinaten der Ausrichtungsmarken 9pl, 9il, 9pr, 9ir in Bezug zum Detektorkoordinatensystem (xdo, ydo). Wird das so kalibrierte optische System in einem folgenden Prozess beispielsweise dazu verwendet, dass die ersten Ausrichtungsmarken einer ersten Substratoberfläche eines ersten Substrats mit den zweiten Ausrichtungsmarken einer zweiten Substratoberfläche eines zweiten Substrats zueinander ausgerichtet werden müssen, dann müssen die vermessenen und gespeicherten translatorisch und/oder rotatorisch Verschiebungen zur Korrektur verwendet werden.

Die Figur 3c zeigt eine schematische, nicht maßstabsgetreue, vereinfachte, vergrößerte Skizze des photosensitiven Bereichs 14so des oberen Kamerachips 2o am Ende des vierten erfindungsgemäßen Prozessschritts 104. Die Ausrichtungsmarken 9pl, 9pr befinden sich an den idealen Positionen 9il, 9ir. Das optische System 11, 11' ,11'' ist damit kalibriert. Obwohl es erklärtes und bevorzugtes Ziel des erfindungsgemäßen Prozesses ist, die projizierten Ausrichtungsmarken 9pl, 9pr mit den idealen Positionen 9il, 9ir zur Deckung zu bringen, wird die Möglichkeit offenbart, die projizierten Ausrichtungsmarken 9pl, 9pr mit den idealen Positionen 9il, 9ir nicht zur Deckung zu bringen und stattdessen die rotatorische Drehung und/oder die translatorischen Verschiebung zwischen den projizierten Ausrichtungsmarken 9pl, 9pr und den idealen Positionen 9il, 9ir zu speichern. Durch diese gespeicherte Information ist eine Koordinaten- und/oder Bildkorrektur jederzeit durchführbar. Die Durchführung einer solchen Koordinaten- und/oder Bildkorrektur ist mit Rechenleistung verbunden. Denkbar ist auch, dass man die Ausrichtungsmarken 9pl, 9pr mit den idealen Positionen 9il, 9ir nicht vollständig zur Deckung bringen kann, insbesondere auf Grund von Toleranzen in den optischen und/oder mechanischen Bauteilen des optischen Systems 11, 11',11". In diesem Fall werden die rotatorische Drehung und/oder die translatorische Verschiebung vorzugsweise ebenfalls gespeichert. Eine Koordinaten- und/oder Bildkorrektur sollte vorzugsweise immer durchgeführt werden um möglichst exakte Ergebnisse zu erhalten.

Figur 4a zeigt eine schematische, nicht maßstabsgetreue, isometrische Explosionsansicht eines zerlegten Kamerachips 2u gemäß einer ersten erfindungsgemäßen Ausführungsform. Der Kamerachip 2u besteht aus einem Chipträger 14, der eine photosensitive Oberfläche 14su besitzt.

Der Chipträger 14 wird meistens mit einer Schutzplatte 15, insbesondere einer Glasplatte, versiegelt. Die Versiegelung ist dabei nur unter enormem Kraftaufwand zu brechen und hat regelmäßig die Zerstörung des Chipträgers 14, insbesondere der photosensitiven Oberfläche 14su, zur Folge. Daher müssen die Ausrichtungsmarken 9l, 9r vorzugsweise vom Chiphersteller vor der Versiegelung mit der Schutzplatte 15, hergestellt werden.

Auf der Schutzplatte 15 können weitere Glasplatten 16, insbesondere optische Filter, montiert und befestigt werden. Meistens werden alle Bauteile 14,15,16 mittels eines Rahmens 17 fixiert.

Figur 4b zeigt eine schematische, nicht maßstabsgetreue, isometrische Explosionsansicht eines zerlegten Kamerachips 2u gemäß einer anderen erfindungsgemäßen Ausführungsform, bei dem eine separate erfindungsgemäße Markierungsplatte 18 mit Ausrichtungsmarken 9l,9r, insbesondere direkt nach der Schutzplatte 15, also möglichst nahe an der photosensitiven Oberfläche 14su fixiert wird. Die Ausrichtungsmarken 9l, 9r befinden sich vorzugsweise an der Seite der Markierungsplatte 18, die der photosensitiven Oberfläche 14su, zugewandt ist, um die Distanz zwischen den Ausrichtungsmarken 9l, 9r und der photosensitiven Oberfläche 14su noch weiter zu reduzieren.

Das Einfügen der Markierungsplatte 18 ist bei den meisten Kamerachips 2u relativ einfach durchzuführen, da sich alle Bauteile oberhalb der Schutzplatte 15, insbesondere sogar gewollt, leicht entfernen lassen. Dadurch sind derartige Kamerachips 2u, insbesondere durch Filter, im speziellen Fall durch eine Markierungsplatte 18, erweiterbar.

Bezugszeichenliste

| 1o, 1u | Kamera |
| 2o, 2u | Kamerachip |
| 3,3o,3u | Spiegel |
| 4, 4' | Linsen |
| 5o, 5u | Optische Ebene, insbesondere Gegenstands- oder Bildebene |
| 6o, 6u | Optik |
| 7, 7',7" | Beleuchtungspfad |
| 8 | Abbildungspfad |
| 9l,9r,9l',9r' | Ausrichtungsmarke |
| 9pl,9pr | Projizierte Ausrichtungsmarke |
| 9il,9ir | ideale Ausrichtungsmarken |
| 10 | Quelle |
| 11, 11',11" | Optisches System |
| 12u,12u',12u" | Optisches Teilsystem |
| 12o,12o',12o" | Optisches Teilsystem |
| 13u, 13o | Optische Achse |
| 14 | Chipträger |
| 14so,14su | Photosensitive Oberfläche |
| 15 | Schutzplatte |
| 16 | Glasplatte, insbesondere Filter |
| 17 | Rahmen |
| 18 | Markierungsplatte |
| 19 | Oberfläche |
| 20 | Kippachse |
| 21 | Ausrichtungsmarkenprojektionssystem |
| α | Winkel zwischen optischen Ebenen |
| A-A | Schnittdarstellung |
| B-B | Schnittdarstellung |
| d | Abstand |
| dx,dy | Abstand |
| tu,to | Schärfentiefebereich |
| xdu,ydu | Koordinaten |

Patentansprüche

1. Verfahren zur Ausrichtung zweier gegenüberliegend, insbesondere übereinander, angeordneter optischer
Teilsysteme (12u,12u',12u",12o,12o',12o") eines optischen Systems (11,11',11"), mit den folgenden Schritten:

- Projektion von Ausrichtungsmarken (9l,9r,9l',9r') in eine Bildebene (5u) des ersten, insbesondere unteren, optischen Teilsystems (12u,12u',12u"),
- Projektion der Ausrichtungsmarken (9l,9r,9l',9r') von der ersten Bildebene (5u) auf eine sensitive Oberfläche (14so) des zweiten, insbesondere oberen, optischen Teilsystems (12o,12o',12o"),
- Ausrichtung der optischen Teilsysteme (12u,12u',12u",12o,12o',12o") zueinander, so dass Projektionen (9pl,9pr) der Ausrichtungsmarken (9l,9r,9l',9r') in einem Schärfentiefebereich der sensitiven Oberfläche (14so) an idealen Positionen (9il,9ir) abgebildet werden.
- wobei ein Keilfehler zwischen der Bildebene (5u) des ersten optischen Teilsystems (12u, 12u', 12u") und einer Bildebene (5o) des zweiten optischen Teilsystems (12o, 12o', 12o") korrigierbar ist.

**2.** Verfahren nach Anspruch 1, wobei Licht (7) zur Beleuchtung der Ausrichtungsmarken (9l,9r) über mindestens eine Lichtquelle (10), insbesondere eine Lampe, bevorzugt eine Halogenlampe, und mindestens einen Spiegel (3) in das erste und/oder zweite optische Teilsystem (12u,12u',12u",12o,12o',12o") eingekoppelt wird.

**3.** Verfahren nach einem der vorhergehenden Ansprüche, wobei an mindestens einer Stelle der optischen Teilsysteme (12u,12u',12u",12o,12o',12o"), insbesondere an einer ersten Kamera (1u) und/oder an einem Spiegel (3,3u,3o), Umgebungslicht (7') zur Beleuchtung der Ausrichtungsmarken (9l,9r) eingekoppelt wird, wobei bevorzugt eine Abschirmung der optischen Teilsysteme (12u,12u',12u",12o,12o',12o") nicht verbaut wird.

**4.** Verfahren nach einem der vorhergehenden Ansprüche, wobei die Ausrichtungsmarken (9l',9r') von einem Ausrichtungsmarkenprojektionssystem (21) auf eine erste sensitive Oberfläche (14su) eines ersten Kamerachips (2u) einer ersten Kamera (1u) projiziert werden, wobei die Ausrichtungsmarken (9l',9r') insbesondere ein LED Feld umfassen und/oder als Masken ausgebildet sind.

**5.** Verfahren nach einem der vorhergehenden Ansprüche, wobei die optischen Teilsysteme (12u,12u',12u",12o,12o',12o") zwei sich gegenüberliegend angeordnete Optiken (6o,6u), umfassen, deren Bildebenen (5o,5u) und/oder optische Achsen (13o,13u) zueinander ausgerichtet werden.

**6.** Verfahren nach Anspruch 5, wobei zumindest die Optiken (6o,6u) Teil einer Anlage zur Ausrichtung von Substraten, insbesondere Wafern, sind.

**7.** Verfahren nach Anspruch 5 oder 6, mit dem folgenden Ablauf:

- Anordnung von Ausrichtungsmarken (9l,9r) in der Nähe und/oder auf einer ersten sensitiven Oberfläche (14su) eines ersten Kamerachips (2u) einer ersten Kamera (1u) und/oder Projektion von Ausrichtungsmarken (9l',9r') auf eine erste sensitive Oberfläche (14su) eines ersten Kamerachips (2u) einer ersten Kamera (1u),
- Projektion der Ausrichtungsmarken (9l,9r,9l',9r') vom ersten Kamerachip (2u) über das erste optische Teilsystem (12u,12u',12u") in die erste Bildebene (5u), wobei das erste optische Teilsystem (12u,12u',12u") die erste Optik (6u) aufweist, wobei die erste Bildebene (5u) zwischen den Optiken (6o,6u) angeordnet ist,
- Projektion der Ausrichtungsmarken (9l,9r,9l',9r') von der ersten Bildebene (5u) über das zweite optische Teilsystem (12o,12o',12o") auf die zweite sensitive Oberfläche (14so) eines zweiten Kamerachips (2o) einer zweiten Kamera (1o), wobei das zweite optische Teilsystem (12o,12o',12o") die zweite Optik (6o) aufweist.

**8.** Verfahren nach Anspruch 5, 6 oder 7, wobei die Optiken (6o,6u) zur Ausrichtung translatorisch und/oder rotatorisch zueinander bewegt werden.

**9.** Verfahren nach Anspruch 5, 6, 7 oder 8, wobei die Optiken (6o,6u) zur Ausrichtung derart angenähert werden, dass sich die erste Bildebene (5u) der ersten Optik (6u) in einem Schärfentiefebereich to der zweiten Gegenstandsebene (5o) der zweiten Optik (6o) befindet.

**10.** Verfahren nach einem der vorhergehenden Ansprüche, wobei die Ausrichtungsmarken (9l,9r) direkt auf einer ersten sensitiven Oberfläche (14su) eines ersten Kamerachips (2u) einer ersten Kamera (1u) aufgebracht sind

**11.** Verfahren nach einem der vorhergehenden Ansprüche, wobei die Ausrichtungsmarken (9l,9r) direkt auf einer ersten sensitiven Oberfläche (14su) eines ersten Kamerachips (2u) aufgebracht sind, wobei die Ausrichtungsmarken (9l,9r) eine, insbesondere eine Kreuzform aufweisende, Ansammlung nicht funktionsfähiger Pixel aufweisen.

**12.** Verfahren nach einem der vorhergehenden Ansprüche, wobei die Ausrichtungsmarken (9l,9r) auf eine separate Markierungsplatte (18) in einem ersten Kamerachip (2u) einer ersten Kamera (1u) aufgebracht sind, wobei der Abstand zwischen den Ausrichtungsmarken (9l,9r) und einer ersten sensitiven Oberfläche (14su) des ersten Kamerachips (2u) kleiner 1 mm ist, vorzugsweise kleiner als 100 μm, noch bevorzugter kleiner als 10 μm, am bevorzugtesten kleiner als 1 μm, am allerbevorzugtesten kleiner als 0.1 μm.

**13.** System (11,11',11") zur Ausrichtung zweier gegenüberliegend, insbesondere übereinander, angeordneter optischer Teilsysteme (12u,12u',12u",12o,12o',12o") des optischen Systems (11,11',11"), insbesondere mit einem Verfahren nach einem der vorhergehenden Patentansprüche, aufweisend:

- Eine erste Kamera (1u) mit einem ersten Kamerachip (2u) zur Projektion von Ausrichtungsmarken (9l,9r,9l',9r') in eine Bildebene (5u) des ersten, insbesondere unteren, optischen Teilsystems (12u,12u',12u"),
- Mittel zur Projektion der Ausrichtungsmarken (9l,9r,9l',9r') von der ersten Bildebene (5u) auf eine sensitive Oberfläche (14so) des zweiten, insbesondere oberen, optischen Teilsystems (12o,12o',12o"),
- Mittel zur Ausrichtung der optischen Teilsysteme (12u,12u',12u",12o,12o',12o") zueinander, so dass Projektionen (9pl,9pr) der Ausrichtungsmarken (91,9r,91',9r') in einem Schärfentiefebereich der sensitiven Oberfläche (14so) an idealen Positionen (9il,9ir) abbildbar sind.
- wobei ein Keilfehler zwischen der Bildebene (5u) des ersten optischen Teilsystems (12u, 12u', 12u") und einer Bildebene (5o) des zweiten optischen Teilsystems (12o, 12o', 12o") korrigierbar ist.

14. System (11,11',11") nach Anspruch 13, wobei die Ausrichtungsmarken (91',9r') von einem Ausrichtungsmarkenprojektionssystem (21) auf eine erste sensitive Oberfläche (14su) des ersten Kamerachips (2u) der ersten Kamera (1u) projiziert werden, wobei die Ausrichtungsmarken (91',9r') insbesondere ein LED Feld umfassen und/oder als Masken ausgebildet sind.

15. Kamerachip (2u) mit Ausrichtungsmarken (9l,9r) in der Nähe und/oder auf seiner sensitiven Oberfläche (14su), für ein Verfahren nach Anspruch 12.


**Claims**

1. A method for the alignment of two optical sub-systems (12u, 12u', 12u", 12o, 12o', 12o") of an optical system (11, 11', 11"), said optical sub-systems being arranged mutually opposite one another, in particular one above the other, with the following steps:

   - projection of alignment marks (91, 9r, 91', 9r') into an image plane (5u) of the first, in particular lower, optical sub-system (12u, 12u', 12u"),
   - projection of the alignment marks (91, 9r, 91', 9r') from the first image plane (5u) onto a sensitive surface (14so) of the second, in particular upper, optical sub-system (12o, 12o', 12o"),
   - alignment of the optical sub-systems (12u, 12u', 12u", 12o, 12o', 12o") with one another, so that projections (9pl, 9pr) of the alignment marks (91, 9r, 91', 9r') are imaged in a depth of focus range of the sensitive surface (14so) at ideal positions (9il, 9ir),
   - wherein a wedge error between the image plane (5u) of the first optical sub-system (12u, 12u', 12u") and an image plane (5o) of the second optical sub-system (12o, 12o', 12o") can be corrected.

2. The method according to claim 1, wherein light (7) for illuminating the alignment marks (91, 9r) by means of at least one light source (10), in particular a lamp, preferably a halogen lamp, and at least one mirror (3) is coupled into the first and/or second optical sub-system (12u, 12u', 12u", 12o, 12o', 12o").

3. The method according to any one of the preceding claims, wherein ambient light (7') for illuminating the alignment marks (91, 9r) is coupled in at at least one point of the optical sub-systems (12u, 12u', 12u", 12o, 12o', 12o"), in particular at a first camera (1u) and/or at a mirror (3, 3u, 3o), wherein shielding of the optical sub-systems (12u, 12u', 12u", 12o, 12o', 12o") is preferably not incorporated.

4. The method according to any one of the preceding claims, wherein the alignment marks (91', 9r') are projected by an alignment mark projection system (21) onto a first sensitive surface (14su) of a first camera chip (2u) of a first camera (1u), wherein the alignment marks (91', 9r') comprise in particular an LED field and/or are constituted as masks.

5. The method according to any one of the preceding claims, wherein the optical sub-systems (12u, 12u', 12u", 12o, 12o', 12o") comprise two lenses (6o, 6u) arranged opposite one another, the image planes (5o, 5u) and/or optical axes (13o, 13u) whereof are aligned with one another.

6. The method according to claim 5, wherein at least the lenses (6o, 6u) are part of a system for the alignment of substrates, in particular wafers.

7. The method according to claim 5 or 6, with the following sequence:

   - arrangement of alignment marks (9l, 9r) in the vicinity of and/or on a first sensitive surface (14su) of a first camera chip (2u) of a first camera (1u) and/or projection of alignment marks (9l', 9r') onto a first sensitive surface (14su) of a first camera chip (2u) of a first camera (1u),
   - projection of the alignment marks (9l, 9r, 9l', 9r') from the first camera chip (2u) via the first optical sub-system (12u, 12u', 12u") into the first image plane (5u), wherein the first optical sub-system (12u, 12u', 12u") comprises the first lens (6u), wherein the first image plane (5u) is arranged between the lenses (6o, 6u),
   - projection of the alignment marks (9l, 9r, 91', 9r') from the first image plane (5u) via the second optical sub-system (12o, 12o', 12o") onto the second sensitive surface (14so) or a second camera chip (2o) of a second camera (1o), wherein the second optical sub-system (12o, 12o', 12o") comprises the second lens (6o).

8. The method according to claim 5, 6 or 7, wherein the lenses (6o, 6u) are moved with respect to one another in translation and/or in rotation for the alignment.

9. The method according to claim 5, 6, 7 or 8, wherein the lenses (6o, 6u) are caused to approach one another for the alignment, in such a way that the first image plane (5u) of the first lens (6u) is located in a depth of focus range to of the second object plane (5o) of the second lens (6o).

10. The method according to any one of the preceding claims, wherein the alignment marks (9l, 9r) are applied directly on a first sensitive surface (14su) of a first camera chip (2u) of a first camera (1u).

11. The method according to any one of the preceding claims, wherein the alignment marks (9l, 9r) are applied directly on a first sensitive surface (14su) of a first camera chip (2u), wherein the alignment marks (9l, 9r) comprise a cluster of non-operative pixels, in particular having a cross shape.

12. The method according to any one of the preceding claims, wherein the alignment marks (9l, 9r) are applied on a separate marking plate (18) in a first camera chip (2u) of a first camera (1u), wherein the distance between the alignment marks (9l, 9r) and a first sensitive surface (14su) of the first camera chip (2u) is less than 1 mm, preferably less than 100 $\mu$m, still more preferably less than 10 $\mu$m, most preferably less than 1 $\mu$m, with utmost preference less than 0.1 $\mu$m.

13. A system (11, 11', 11") for the alignment of two optical sub-systems (12u, 12u', 12u", 12o, 12o', 12o") of the optical system (11, 11', 11"), said optical sub-systems being arranged mutually opposite one another, in particular one above the other, in particular using a method according to any one of the preceding claims, comprising:

- a first camera (1u) with a first camera chip (2u) for the projection of alignment marks (9l, 9r, 9l', 9r') into an image plane (5u) of the first, in particular lower, optical sub-system (12u, 12u', 12u"),
- means for the projection of the alignment marks (9l, 9r, 9l', 9r') from the first image plane (5u) onto a sensitive surface (14so) of the second, in particular upper, optical sub-system (12o, 12o', 12o"),
- means for the alignment of the optical sub-systems (12u, 12u', 12u", 12o, 12o', 12o") with one another, so that projections (9pl, 9pr) of the alignment marks (9l, 9r, 9l', 9r') can be imaged in a depth of focus range of the sensitive surface (14so) at ideal positions (9il, 9ir),

- wherein a wedge error between the image plane (5u) of the first optical sub-system (12u, 12u', 12u") and an image plane (5o) of the second optical sub-system (12o, 12o', 12o") can be corrected.

14. The system (11, 11', 11") according to claim 13, wherein the alignment marks (9l', 9r') are projected by an alignment mark projection system (21) onto a first sensitive surface (14su) of the first camera chip (2u) of the first camera (1u), wherein the alignment marks (9l', 9r') comprise in particular an LED field and/or are constituted as masks.

15. A camera chip (2u) with alignment marks (9l, 9r) in the vicinity of and/or on its sensitive surface (14su), for a method according to claim 12.

**Revendications**

1. Procédé d'alignement de deux systèmes optiques partiels (12u, 12u', 12u", 12o, 12o', 12o") opposés, disposés en particulier l'un sur l'autre, d'un système optique (11, 11', 11"), comprenant les étapes suivantes :

- projection de repères d'alignement (9l, 9r, 9l', 9r') dans un plan d'image (5u) du premier système optique partiel, en particulier inférieur (12u, 12u', 12u"),
- projection des repères d'alignement (9l, 9r, 9l', 9r') du premier plan d'image (5u) sur une surface sensible (14so) du second système optique partiel, en particulier supérieur (12o, 12o', 12o"),
- alignement des systèmes optiques partiels (12u, 12u', 12u", 12o, 12o', 12o") entre eux, de façon à ce que des projections (9pl, 9pr) des repères d'alignement (9l, 9r, 9l', 9r') soient reproduites à des positions idéales (9il, 9ir) dans une plage de profondeur de champ de la surface sensible (14so),
- dans lequel une erreur de coin entre le plan d'image (5u) du premier système optique partiel (12u, 12u', 12u") et un plan d'image (5o) du second système optique partiel (12o, 12o', 12o") peut être corrigée.

2. Procédé selon la revendication 1, dans lequel de la lumière (7) pour éclairer les repères d'alignement (9l, 9r) est envoyée par le biais d'au moins une source lumineuse (10), en particulier une lampe, de préférence une lampe halogène, et au moins d'un miroir (3), dans le premier et/ou le second système partiel optique (12u, 12u', 12u", 12o, 12o', 12o").

3. Procédé selon l'une quelconque des revendications précédentes, dans lequel de la lumière ambiante (7') pour éclairer les repères d'alignement (9l, 9r) est envoyée sur au moins un endroit des systèmes optiques partiels (12u, 12u', 12u", 12o, 12o', 12o"), en particulier sur une première caméra (1u) et/ou sur un miroir (3, 3u, 3o), dans lequel de préférence un blindage des systèmes optiques partiels (12u, 12u', 12u", 12o, 12o', 12o") n'est pas monté.

4. Procédé selon l'une quelconque des revendications précédentes, dans lequel les repères d'alignement (9l, 9r) sont projetés par un système de projection de repères d'alignement (21) sur une première surface sensible (14su) d'une première puce de caméra (2u) d'une première caméra (1u), dans lequel les repères d'alignement (9l, 9r) comprennent en particulier un champ de LED et/ou sont conçus en tant que masques.

5. Procédé selon l'une quelconque des revendications précédentes, dans lequel les systèmes optiques partiels (12u, 12u', 12u", 12o, 12o', 12o") comprennent deux optiques (6o, 6u) disposées opposées, dont les plans d'image (5o, 5u) et/ou axes optiques (13o, 13u) sont alignés l'un vers l'autre.

6. Procédé selon la revendication 5, dans lequel au moins les optiques (6o, 6u) font partie d'une installation pour aligner des substrats, en particulier des pastilles.

7. Procédé selon la revendication 5 ou 6, comprenant le déroulement suivant :

   - alignement de repères d'alignement (9l, 9r) à proximité de et/ou sur une première surface sensible (14su) d'une première puce de caméra (2u) d'une première caméra (1u) et/ou projection de repères d'alignement (9l', 9r') sur une première surface sensible (14su) d'une première puce de caméra (2u) d'une première caméra (1u),
   - projection des repères d'alignement (9l, 9r, 9l', 9r') de la première puce de caméra (2u) dans le premier plan d'image (5u) par le biais du premier système optique partiel (12u, 12u', 12u''), dans lequel le premier système optique partiel (12u, 12u', 12u") présente la première optique (6u), dans lequel le premier plan d'image (5u) est disposé entre les optiques (6o, 6u),
   - projection des repères d'alignement (9l, 9r, 9l', 9r') du premier plan d'image (5u) sur la seconde surface sensible (14so) d'une seconde puce de caméra (2o) d'une seconde caméra (1o) par le biais du second système optique partiel (12o, 12o', 12o"), dans lequel le second système optique partiel (12o, 12o', 12o") présente la seconde optique (6o).

8. Procédé selon la revendication 5, 6 ou 7, dans lequel les optiques (6o, 6u) sont déplacées en translation et/en rotation l'une par rapport à l'autre pour l'alignement.

9. Procédé selon la revendication 5, 6 , 7 ou 8, dans lequel les optiques (6o, 6u) sont rapprochées de telle façon pour l'alignement que le premier plan d'image (5u) de la première optique (6u) se trouve dans une plage de profondeur de champ to du second plan d'objet (5o) de la seconde optique (6o).

10. Procédé selon l'une quelconque des revendications précédentes, dans lequel les repères d'alignement (9l, 9r) sont appliqués directement sur une première surface sensible (14su) d'une première puce de caméra (2u) d'une première caméra (1u).

11. Procédé selon l'une quelconque des revendications précédentes, dans lequel les repères d'alignement (9l, 9r) sont appliqués directement sur une première surface sensible (14su) d'une première puce de caméra (2u), dans lequel les repères d'alignement (9l, 9r) présentent une accumulation de pixels non opérationnels, présentant en particulier une forme croisée.

12. Procédé selon l'une quelconque des revendications précédentes, dans lequel les repères d'alignement (9l, 9r) sont appliqués sur une plaque de repérage (18) séparée dans une première puce de caméra (2u) d'une première caméra (1u), dans lequel la distance entre les repères d'alignement (9l, 9r) et une première surface sensible (14su) de la première puce de caméra (2u) est inférieure à 1 mm, de préférence inférieure à 100 $\mu$m, plus encore de préférence inférieure à 10 $\mu$m, de manière la plus préférée inférieure à 1 $\mu$m, de manière préférée entre toutes inférieure à 0,1 $\mu$m.

13. Système (11, 11', 11") d'alignement de deux systèmes optiques partiels (12u, 12u', 12u", 12o, 12o', 12o") opposés, disposés en particulier l'un sur l'autre, du système optique (11, 11', 11"), en particulier avec un procédé selon l'une des revendications précédentes, comprenant :

   - une première caméra (1u) avec une première puce de caméra (2u) pour la projection de repères d'alignement (9l, 9r, 9l', 9r') dans un plan d'image (5u) du premier système optique partiel, en particulier inférieur (12u, 12u', 12u"),
   - des moyens de projection des repères d'alignement (9l, 9r, 9l', 9r') du premier plan d'image (5u) sur une surface sensible (14so) du second système optique partiel, en particulier supérieur (12o, 12o', 12o"),
   - des moyens d'alignement des systèmes optiques partiels (12u, 12u', 12u", 12o, 12o', 12o") entre eux, de façon à ce que des projections (9pl, 9pr) des repères d'alignement (9l, 9r, 9l', 9r') puissent être reproduites à des positions idéales (9il, 9ir) dans une plage de profondeur de champ de la surface sensible (14so),
- dans lequel une erreur de coin entre le plan d'image (5u) du premier système optique partiel (12u, 12u', 12u") et un plan d'image (5o) du second système optique partiel (12o, 12o', 12o") peut être corrigée.

14. Système (11, 11', 11") selon la revendication 13, dans lequel les repères d'alignement (9l', 9r') sont projetés par un système de projection de repères d'alignement (21) sur une première surface sensible (14su) de la première puce de caméra (2u) de la première caméra (1u), dans lequel les repères d'alignement (9l', 9r') comprennent en particulier un champ de LED et/ou sont conçus en tant que masques.

15. Puce de caméra (2u) comprenant des repères d'alignement (9l, 9r) à proximité de et/ou sur une première surface sensible (14su), pour un procédé selon la revendication 12.

Fig. 1a

EP 3 596 751 B1

ERSATZBLATT (REGEL 26)

Fig. 1b

Fig. 1c

Fig 2a

101

Fig 2b

EP 3 596 751 B1

22

Fig 2c

103

EP 3 596 751 B1

Fig 2d

104

Fig 3a

xdu 9l 14su

ydu

9r

Fig 3b

104

xdo 9pl 9il 14so

ydo

9pr

9ir

Fig 3c

104

xdo 9pl 9il 14so

ydo

9pr

Fig 4a

2u

9l 14su

14

9r

15

16

17

Fig 4b

2u

12 13

14su

9l

15

18

9r

16

17

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6214692 B1
- WO 2014202106 A1
- WO 2015082020 A1
- JP 2003303865 A
- WO 2011042093 A1